# EUROPEAN PATENT APPLICATION

(11) **EP 0 881 503 A2**
(43) Date of publication of application: **02.12.1998**
(21) Application number: 98303656.7
(22) Date of filing: 11.05.1998
(51) Int. Cl.: G01R 33/09, G11B 5/39, G01C 17/28

(54) **Magneto-impedance effect element and magnetic head, electronic compass and autocanceller using the element**

(30) Priority: 26.05.1997 JP 135597/97; 21.08.1997 JP 225392/97; 26.08.1997 JP 229989/97; 29.08.1997 JP 235278/97; 29.08.1997 JP 235283/97
(71) Applicant: ALPS ELECTRIC CO., LTD., Ota-ku Tokyo 145 (JP); Inoue, Akihisa, Sendai-shi, Miyagi-ken (JP)
(72) Inventor: Mizushima, Takao, Nagaoka-shi, Niigata-ken (JP); Makino, Akihiro, Nagaoka-shi, Niigata-ken (JP); Sudo, Yoshihiro, Kurokawa-gun, Miyagi-ken (JP); Sasagawa, Shinichi, Furukawa-shi, Miyagi-ken (JP); Inoue, Akihisa, Sendai-shi, Miyagi-ken (JP)
(74) Representative: Kensett, John Hinton

(57) **Abstract**

The present invention provides a magneto-impedance effect element composed of a Fe-based glassy alloy containing Fe as a main component and having a supercooled liquid region having a temperature width ΔTx of 35°C or more, which is expressed by the equation ΔTx = Tx - Tg (wherein Tx is the crystallization temperature, and Tg is the glass transition temperature), wherein impedance changes depending upon an external magnetic field with the alternating current applied. The present invention also provides a magnetic head, a thin film magnetic head, an electronic compass and an autocanceller each of which uses the magneto-impedance effect element.

## Description

The present invention relates to a magneto-impedance effect element using a Fe-based glassy alloy, and a magnetic head, an electronic compass for sensing the direction of lines of magnetic force due to geomagnetism, and an autocanceller comprising a magnetic sensor and provided in a display or the like comprising a cathode ray tube, each of which uses the magneto-impedance effect element.

A smaller magnetic field sensing element having higher sensitivity and higher responsiveness than a conventional magnetic flux sensing type magnetic sensor has been demanded with recent rapid development in information devices, measuring devices, and control devices, and an element (a magneto-impedance effect element referred to as an "MI element" hereinafter) having a magneto-impedance effect has attracted attention.

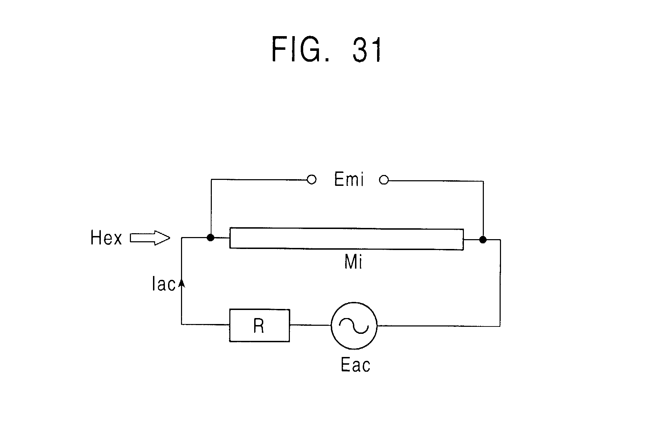

The magneto-impedance effect represents the phenomenon that for example, in the closed circuit shown in Fig. 31, when an alternating current Iac in the MHz bond is applied to a wire- or ribbon-shaped magnetic material Mi from a power source Eac, and an external magnetic field Hex is applied to the magnetic material Mi in the lengthwise direction thereof, a voltage Emi due to the inherent impedance of the material is generated at both ends of the magnetic material Mi even if the external magnetic field Hex is as small as several gauss, and the amplitude of the voltage changes in a range of several tens % in correspondence with the strength of the external magnetic field Hex, i.e., an impedance change occurs. An element (MI element) having the magneto-impedance effect is sensitive to an external magnetic field in the lengthwise direction thereof. Therefore, in the use of such an element as a magnetic field sensor, unlike a conventional magnetic flux sensing type magnetic field sensor using a coiled magnetic core, magnetic field sensitivity does not deteriorate even if the length of the sensor head is about 1 mm or less, a weak magnetic field sensor having resolution of about 10-5 Oe can be obtained, and magnetization (excitation) of several MHz or more is possible. Therefore, a high-frequency magnetic field of 200 to 300 MHz can be used as an amplitude modulation carrier, and the cut-off frequency of the magnetic field sensor can easily be set to 10 MHz or more. The element is thus expected to be applied as a new micro-magnetic head and a weak magnetic field sensor.

As materials having the magneto-impedance effect, (S) Fe-Si-B system alloys, e.g., Fe₇₈Si₉B₁₃ amorphous ribbons, and (R) Fe-Co-Si-B system alloys, e.g., (Fe₆Co₉₄)_{72.5}Si_{12.5}B₁₅ amorphous wires (Kaneo Mouri, et al., "Magneto-Impedance (MI) Element" Electronic Society Magnetics Research Meeting Material Vol. 1, MAG-94, No. 75-84, PP. 27-36, 1994) have conventionally been reported.

In recent years, there has been demand for improving the recording density of a magnetic recording device such as a hard disk serving as an external memory device of a computer, a digital audio tape recorder, a digital video tape recorder, or the like with a further decrease in size.

In order to comply with the demand, it is essential to increase the performance of a magnetic head, and a magnetic head comprising a magneto-resistance element (referred to as a "MR element" hereinafter) as a reproducing head has recently been developed.

The magnetic head comprising the MR element has no dependence on the speed relative to a recording medium, and is suitable for reading record signals at a low relative speed. However, such a magnetic head is not sensitive enough to output signals due to low resistance rate with change in recording magnetization of the recording medium, and thus has a problem in that it is difficult to comply with a further increase in recording density.

A conventional example using the MI element as magnetic field sensing means for a magnetic head will be described with reference to the drawings.

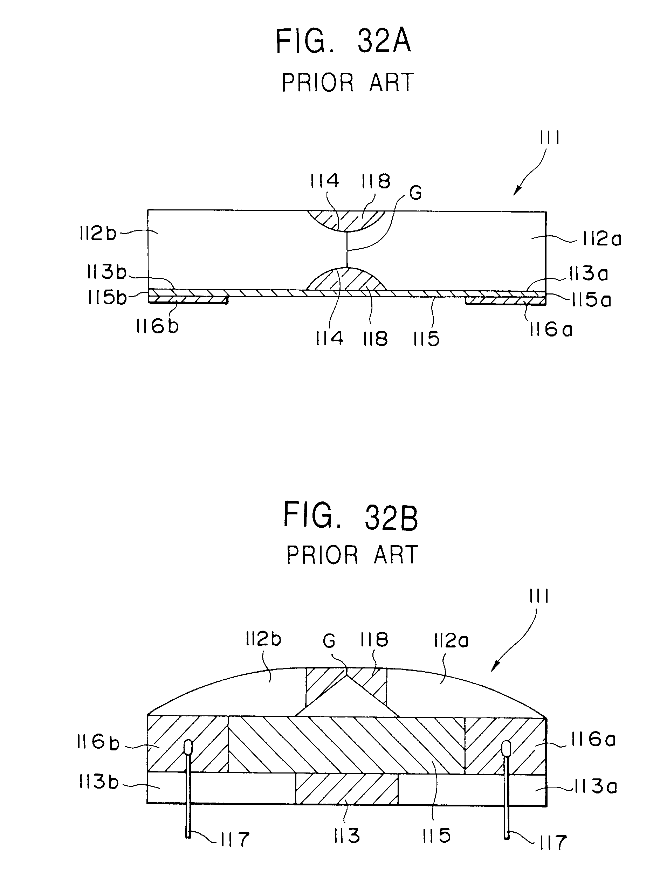

In Figs. 32(A) and 32(B), a magnetic head 111 comprises a pair of cores 112a and 112b made of ferrite, which is an oxide ferromagnetic material, junction glass 113 joined to the pair of cores 112a and 112b so as to be held therebetween, and a magneto-impedance effect element (MI element) 115 made of a magnetic material.

In the magnetic head 111, the MI element 115 is arranged over the sides of the pair of cores 112a and 112b so that the pair of cores 112a and 112b are magnetically bonded through the MI element 115.

Specifically, the lengthwise ends 115a and 115b of the MI element 115 are joined to the magnetic path connecting surfaces 113a and 113b which are surfaces of the pair of cores 112a and 112b. An insulation layer not shown in the drawings is formed on the magnetic path connecting surfaces 113a and 113b.

In this way, a closed magnetic circuit is formed by the pair of the cores 112a and 112b and the MI element 115.

The junction glass 113 is made of a non-magnetic material, has the function to prevent direct magnetic coupling between the pair of the cores 112a and 112b, and is provided for joining the lower portions of the opposite sides of the cores 112a and 112b.

Also a magnetic gap G is provided between the upper portions of the pair of the cores 112a and 112b.

Further, a regulation groove 114 is provided on the upper portions of the pair of the cores 112a and 112b, for regulating the track width of the magnetic gap G, the regulation groove 114 being filled with glass 118 which is a non-magnetic material.

On the lengthwise ends 115a and 115b of the MI element 115 are formed conductive films of Cu, Au or the like to form terminals 116a and 116b, respectively, and leads 117 for outputting output signals are respectively connected to the terminals 116a and 116b. Further, to the terminals 116a and 116b are respectively connected leads (not shown) for applying alternating currents.

The operation of the magnetic head 111 is as described below. An external magnetic field due to recording magnetization of a recording medium not shown in the drawings enters the cores 112a and 112b from the magnetic gap G, and is applied to the MI element 115. The MI element 115 to which an alternating current in the MHz band has previously been applied generates a voltage due to the inherent impedance of the material at both ends of the MI element 115. The amplitude of the voltage changes in the range of several tens % in correspondence with the strength of the external magnetic field, and is output as an output signal through the leads 117.

In the magnetic head 111 using the MI element 115, since the output voltage change is large even if the external magnetic field applied to the MI element 115 from the recording medium is as weak as several gauss, the sensitivity of the magnetic head 111 can be improved.

Also, since sufficient sensitivity can be obtained even if the external magnetic field applied to the cores 112a and 112b is weak, the effective sectional area of the magnetic flux of the magnetic path, i.e., the shape of each of the cores 112a and 112b, can be decreased, and thus the size of the magnetic head 111 can be decreased.

Further, since the MI element is capable of sensing magnetization of about 10⁻⁵ Oe, while a conventional MR element has a sensitivity of about 0.1 Oe, the magnetic head can be expected as a magnetic head with high sensitivity.

Next, an electronic compass is capable of measuring the direction of lines of magnetic force due to an external magnetic field such as geomagnetism or the like by itself, and is widely used as a vehicle compass or automatic position sensing means of a navigation system or the like.

Of electronic compasses, a flux gate sensor is excellent in stability from the viewpoint of the operation principle, and has a magnetic sensitivity of as high as 10⁻⁷ to 10⁻⁶ G, and is thus widely used.

However, since the flux gate sensor comprises a magnetic core ring, a magnetization coil wound around the core, for applying a magnetic field, and a sensing coil for sensing the magnetic flux density of the magnetic core, it has a block shape and has a problem in that the size thereof cannot be decreased.

On the other hand, as another electronic compass, a magnetic sensor comprising the magneto-resistance element (referred to as "the MI element" hereinafter) comprises two MR elements arranged in the same plane so that the current paths of the currents respectively applied to the MR elements cross at right angles, and connected to a bridge or the like to sense the direction of lines of magnetic force due to an external magnetic field. This magnetic sensor has a plane shape, and thus the size thereof can be decreased.

Next , in recent years, the pitch of shadow mask holes of a display (abbreviated to a "CRT display" hereinafter) comprising a cathode ray tube has been decreased with an increase in density of CAD image information. For example, in a CRT display having a screen size of 14 inches, the pitch is 0.28 mm.

Such a high-density screen has a problem in that an electron beam in the cathode ray tube is deviated from the original passage course due to the influence of an external magnetic field such as geomagnetism or the like, thereby causing deterioration in image quality such as shift of an image or unevenness of color due to deterioration in color purity.

Therefore, in order to cancel the influence of geomagnetism, a recent CRT display is generally provided with an atuocanceller comprising a cancel coil for applying, to the cathode ray tube, a magnetic field (cancel magnetic field) of magnitude equal to the lines of magnetic force of geomagnetism in the direction opposite to the lines of magnetic force, and a control unit for controlling the magnitude of the cancel magnetic field. The control unit comprises a magnetic sensor for sensing the direction of geomagnetism.

Like the electronic compass, a flux gate sensor is used as the magnetic sensor of the autocanceller, but has the same problem as the electronic compass. In order to decrease the size, an autocanceller comprising the MR element has recently been brought into practical use.

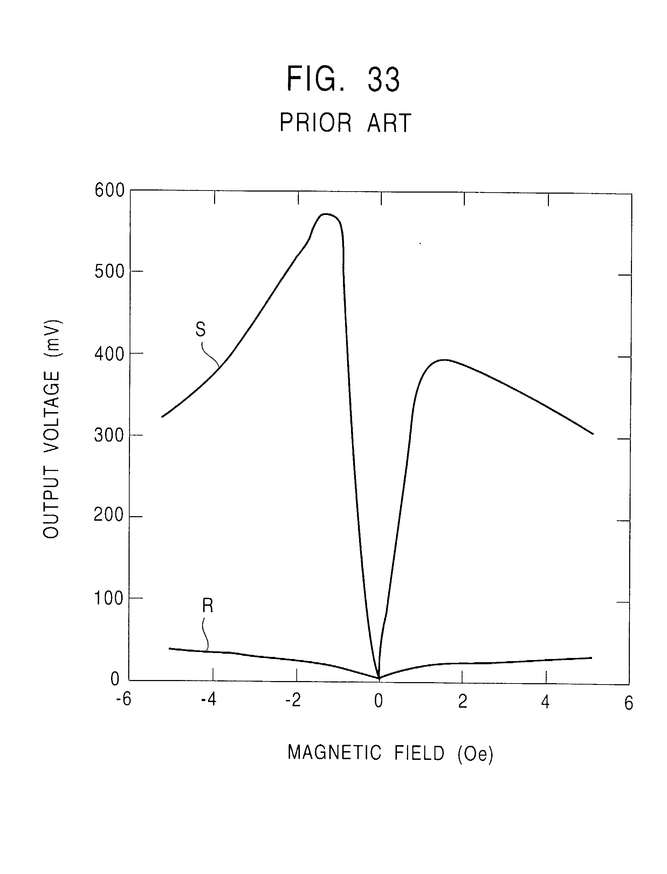

However, in the MI element, the use of the (S) Fe-Si-B system or (R) Fe-Co-Si-B system alloys for the MI element has problems. Namely, as shown in Fig. 33, in measurement of output voltages Emi (mV) for positive and negative applied magnetic fields (Oe), the (S) Fe-Si-B type exhibits low sensitivity to magnetic fields, and thus the amplification factor must be increased to about 100 times, thereby causing entrance of noise and thus difficulties in obtaining a high-sensitivity magnetic field sensing element. As shown in Fig. 33, the (R) Fe-Co-Si-B system alloys has sufficiently high sensitivity, but the sensitivity abruptly rises in the range of weak applied magnetic fields, for example, about - 2 to + 2 Oe, and thus quantitative performance cannot be obtained within this range, thereby causing difficulties in use as a weak magnetic field sensing element. Although the (R) Fe-Co-Si-B system alloys can be used in the band of absolute values of magnetic field of 2 Oe or more, a bias magnetic field of about 2 Oe must be applied, and thus a coil for applying a bias magnetic field must be provided for passing a current to some extent.

In the use of the MI element 115 for the magnetic head 111, the Fe-Si-B system alloys, for example, a Fe₇₈Si₉B₁₃ amorphous alloy ribbon, or the Fe-Co-Si-B system alloys, for example, a (Fe₆Co₉₄)_{72.5} Si_{12.5}B₁₅ amorphous alloy, is used.

However, when an alloy having the composition Fe₇₈Si₉B₁₃ is used as the MI element 115 of the magnetic head 111, the output voltage from the MI element 115 is low for the applied external magnetic field, and the output signal must be amplified about 100 times. This amplification causes entrance of noise and thus a problem in that an output signal with high quality cannot be obtained.

When an alloy having the composition (Fe₆Co₉₄)_{72.5}Si_{12.5}B₁₅ is used as the MI element 115 of the magnetic head 111, the output voltage from the MI element 115 is high for the applied external magnetic field, and the amplification factor of the output signal may be small. However, in the weak external magnetic field range of about - 2 to + 2 Oe, the output voltage rapidly changes, and thus quantitative performance cannot be obtained, thereby causing difficulties in use as magnetic field sensing means of the magnetic head 111.

Even in the band of absolute values of magnetic field of 2 Oe or more in which the output voltage linearly responds to changes in the external magnetic field, the MI element 115 can be used as magnetic field sensing means of the magnetic head 111. However, in this case, a bias magnetic field of about 2 Oe must be applied to the MI element, as described above.

As bias applying means, application of the bias magnetic field by passing a bias current through a coil requires some bias current, and application of the bias magnetic field using a permanent magnet requires selection of the permanent magnet having magnetization of about 2 Oe. This has the problem of complicating the construction of the magnetic head 111.

Further, since both amorphous alloys of Fe₇₈Si₉B₁₃ and (Fe₆Co₉₄)_{72.5}Si_{12.5}H₁₅ have no supercooled liquid region or a supercooled liquid region with a small temperature width ΔTx, in order to obtain an amorphous material, the alloys must be quenched at a rate of 105 °C/s by a single-roll method or the like, and only a thin film having a thickness of 50 µm or less can be obtained. Therefore, the use of these alloys for a magnetic head requires fine processing and has the problem of increasing the production cost of the magnetic head.

Further, in a magnetic sensor using a conventional MI element, the rate of change in resistance of the resistivity of the MI element itself with changes in strength of an external magnetic field is as low as about 3 to 6 %, and sensitivity for resistance change is not enough, thereby there are difficulties in precise measurement of the direction of the lines of magnetic force due to an external magnetic field such as geomagnetism or the like. Therefore, a conventional magnetic sensor has problems in that it is unsuitable for the electronic compass, and in that in the autocanceller, the degree of the cancel magnetic field generated by the cancel coil cannot be optimized, and the autocanceller cannot be normally operated.

In search for a magnetic field sensing element having excellent practical properties, the inventors found that a type of Fe-based glassy alloy is soft magnetic and has the suitable magneto-impedance effect as a magnetic field sensing element, resulting in the achievement of the present invention. Accordingly, a first object of the present invention is to provide a MI element having excellent properties as a magnetic field sensing element.

A second object of the present invention is to provide a magnetic head in which output signals have high quality, the construction thereof is relatively simple, and the production cost is low.

A third object of the present invention is to provide a thin film magnetic head exhibiting ferromagnetic properties at room temperature and using a thin film made of a glassy alloy exhibiting the MI effect for sensing an external magnetic field.

A fourth object of the present invention is to provide an electronic compass and an autocanceller which permit a decrease in size and which are capable of precisely measuring the direction of the lines of magnetic force due to geomagnetism.

In order to achieve the above objects, the present invention provides a MI element comprising a Fe-based glassy alloy containing Fe as a main component and having a supercooled liquid region having a temperature width ΔTx of 35 °C or more, which is expressed by the formula ΔTx = Tx - Tg (wherein Tx is the crystallization temperature, and Tg is the glass transition temperature), wherein impedance changes depending upon an external magnetic field with the alternating current applied.

A magnetic head of the present invention may comprise a pair of cores, junction glass joined to ends of the pairs of cores to be held therebetween, and the above-described magneto-impedance effect element arranged over the pair of cores so that an external magnetic field is applied the magneto-impedance effect element through the pair of cores, as described above.

In a magnetic head of the present invention, as described above, the pair of cores may be of ferrite.

In a magnetic head of the present invention, preferably, a winding groove is provided between the ends of each of the pair of cores, a recording coil being wound in the winding groove.

Further, in a magnetic head of the present invention, preferably, the MI element comprises bias applying means.

Further, in a magnetic head of the present invention, preferably, the bias applying means comprises the bias coil wound in the winding groove.

Further, in a magnetic head of the present invention, preferably, the bias applying means comprises the permanent magnet provided at the end of the MI element.

In order to achieve the objects, the present invention also provides a thin film magnetic head comprising a magneto-impedance effect element thin film for detecting an external magnetic field mainly composed of a Fe-based glassy alloy having a supercooled liquid region having a temperature width ΔTx of 20 °C or more, which is expressed by the equation ΔTx = Tx - Tg (wherein Tx is the crystallization temperature, and Tg is the glass transition temperature), wherein impedance changes with an external magnetic field.

The thin film magnetic head preferably comprises a writing head and a reading head which are provided in a slider relatively moving with a surface opposite to a magnetic medium, wherein the writing head has a magnetic induction type structure comprising thin film upper core and lower core, and a magnetic gap and a coil conductor held between the two cores, and the reading head comprises the magneto-impedance effect element thin film and an electrode film connected to the magneto-impedance effect element thin film.

Preferably, bias applying means is added to the magneto-impedance effect element thin film.

In the present invention, the bias applying means may comprise a permanent magnet connected to the magneto-impedance effect element thin film.

Further, in the present invention, the bias applying means may comprise a ferromagnetic thin film laminated on the magneto-impedance effect element thin film, and an antiferromagnetic thin film laminated on the ferromagnetic thin film so that a bias is applied by an exchange coupling magnetic field induced in the ferromagnetic thin film by the antiferromagnetic thin film.

An electronic compass of the present invention may comprise, as means for sensing the direction of an external magnetic field, a magneto-impedance effect element composed of a Fe-based glassy alloy containing Fe as a main component and having a supercooled liquid region having a temperature width ΔTx of 20 °C or more, which is expressed by the equation ΔTx = Tx - Tg.

Preferably, the electronic compass of the present invention comprises a first magneto-impedance effect element as means for sensing the X-axis component of the lines of magnetic force due to the external magnetic field, and a second magneto-impedance effect element as means for sensing the Y-axis component of the lines of magnetic force due to the external magnetic field.

In the electronic compass, preferably, the first and second magneto-impedance effect elements are arranged in the same plane so that the current paths of the alternating currents respectively applied thereto cross at right angles.

Also, in the electronic compass of the present invention, preferably, a coil for applying bias magnetization is wound around each of the first and second magneto-impedance effect elements along the current path of the alternating current applied thereto.

An autocanceller of the present invention comprises a cancel coil for applying, to a cathode ray tube, a cancel magnetic field of magnitude equivalent to the external magnetic field in the direction opposite to the lines of magnetic force of the external magnetic field, and a control unit for controlling the magnitude of the cancel magnetic field based on the direction of the lines of magnetic force of the external magnetic field sensed by a magnetic sensor, wherein the magnetic sensor comprises a magneto-impedance effect element composed of a Fe-based soft magnetic glassy alloy containing Fe as a main component and having a supercooled liquid region having a temperature width ΔTx of 20 °C or more, which is expressed by the equation ΔTx = Tx - Tg.

In the autocanceller of the present invention, preferably, the magnetic sensor comprises a first magneto-impedance effect element as means for sensing the X-axis component of the lines of magnetic force due to the external magnetic field, and a second magneto-impedance effect element as means for sensing the Y-axis component of the lines of magnetic force due to the external magnetic field.

In the autocanceller of the present invention, preferably, the first and second magneto-impedance effect elements are arranged in the same plane so that the current paths of the alternating currents respectively applied thereto cross at right angles.

Also, in the autocanceller of the present invention, preferably, a coil for applying bias magnetization is wound around each of the first and second magneto-impedance effect elements along the current path of the alternating current applied thereto.

The Fe-based glassy alloy preferably contains a metal element other then Fe, and a semimetal element. The metal element other than Fe is preferably at least one selected from the 3B group and 4B group in the Periodic Table. Particularly, the metal element other than Fe is preferably at least one selected from the group consisting of Al, Ga, In and Sn. On the other hand, the semimetal element is preferably at least one selected from the group consisting of P, C, B, Ge and Si. Particularly, the semimetal element is preferably a group containing at least three elements of P, C and B.

The composition of the Fe-based glassy alloy preferably comprise 1 to 10 atomic % of Al, 0.5 to 4 atomic % of Ga, 9 to 15 atomic % of P, 5 to 7 atomic % of C, 2 to 10 atomic % of B, 0 to 15 atomic % of Si, and Fe as the balance.

The Fe-based glassy alloy preferably contains Ge in the range of 4 atomic % or less, and at least one selected from the group consisting of Nb, Mo, Hf, Ta, W, Zr and Cr in the range of 7 atomic % or less. The Fe-based glassy alloy may further contain at least one selected from the group consisting of Ni and Co in the range of 10 atomic % or less.

The Fe-based glassy alloy may be subjected to heat treatment in the temperature range of 300 to 500°C.

Embodiments of the invention will now be described, by way of example only, with reference to the accompanying drawings, in which:
Fig. 1 is a graph showing magnetic field sensitivity of an example of MI elements of the present invention;
Fig. 2 is a drawing showing a method of producing a MI element of the present invention;
Fig. 3 is a drawing showing another method of producing an MI element of the present invention;
Fig. 4 is a drawing showing the circuit of a sensor using a MI element of the present invention;
Fig. 5 is a perspective view showing a magnetic head in accordance with an embodiment of the present invention;
Fig. 6 is a perspective view showing a magnetic head in accordance with an embodiment of the present invention;
Fig. 7 is a perspective view showing a thin film magnetic head comprising a magneto-impedance effect element thin film in accordance with another embodiment of the present invention;
Fig. 8 is a sectional view showing a principal portion of the thin film magnetic head shown in Fig. 7;
Fig. 9 is a partially sectional perspective view showing the principal portion of the thin film magnetic head shown in Fig. 7;
Fig. 10 is a sectional view showing an example of the magneto-impedance effect element thin film shown in Fig. 7;
Fig. 11 is a sectional view showing another example of the same magneto-impedance effect element thin film;
Fig. 12 is a plan view showing an electronic compass in accordance with a further embodiment of the present invention;

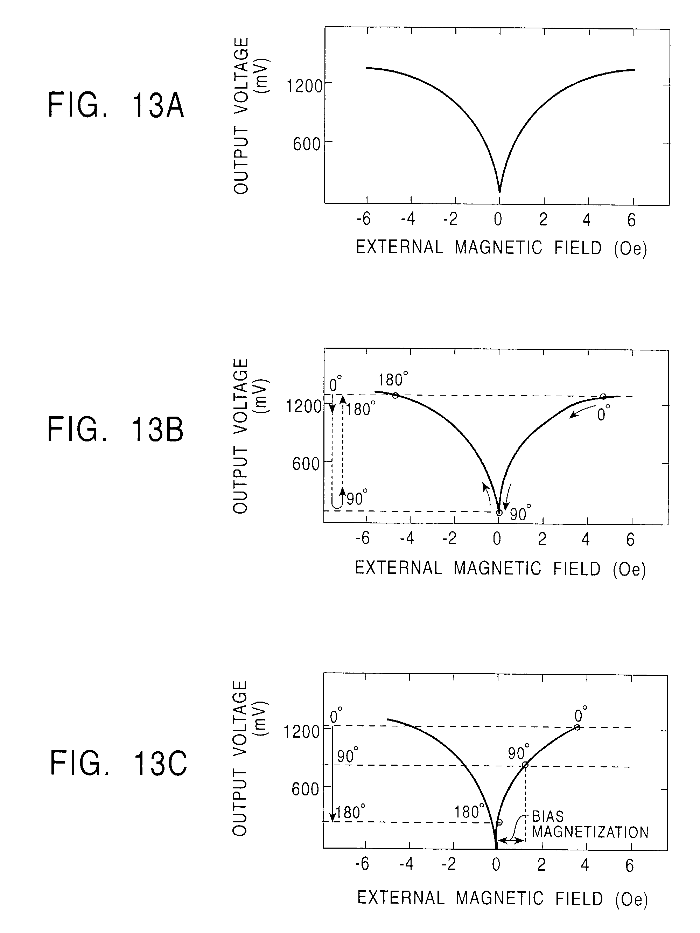

Fig. 13 is a diagram showing the relation between an external magnetic field and output voltage of a MI element in accordance with an embodiment of the present invention, in which Fig. 13A is a graph showing the relation between the external magnetic field and output voltage of the MI element, Fig. 13B is a graph showing the relation between the external magnetic field and output voltage when the direction of the lines of magnetic force of the external magnetic field was changed in the range of 0 to 180° with respect to the lengthwise direction of the MI element, and Fig. 13C is a graph showing the relation between the external magnetic field and output voltage when the direction of the lines of magnetic force of the external magnetic field was changed in the same manner as in Fig. 13B with bias magnetization applied to the MI element;
Fig. 14 is a perspective view showing an autocanceller in accordance with a still further embodiment of the present invention;
Fig. 15 is a graph showing magnetic field sensitivity of an example of the MI element of the present invention;
Fig. 16 is a graph showing magnetic field sensitivity of another example of the MI element of the present invention;
Fig. 17 is an X-ray diffraction chart of an example of the MI element of the present invention;
Fig. 18 is a DSC chart of an example of the MI element of the present invention;
Fig. 19 is a DSC chart of an example of the MI element of the present invention;
Fig. 20 is a graph showing the dependence of Tx, Tg and ΔTx on the thickness of an example of the MI element of the present invention;
Fig. 21 is an X-ray diffraction chart of another example of the MI element of the present invention;
Fig. 22 is a graph showing the dependence of Tx and Tg on the Fe concentration of an example of the MI element of the present invention;
Fig. 23 is an X-ray diffraction chart of a further example of the MI element of the present invention;
Fig. 24 is a DSC chart of an example of the MI element of the present invention; and
Fig. 25 is a graph showing the dependence of Tx, Tg and ΔTx on thickness of an example of the MI element of the present invention;
Fig. 26 is a graph showing the dependence of saturation magnetization, coercive force and magnetic permeability on the heat treatment temperature with respect to a quenched ribbon having the composition Fe₇₃Al₅Ga₂P₁₁C₅B₄;
Fig. 27 is a graph showing the data extracted from the data of the dependence on the heat treatment temperature shown in Fig. 26;
Fig. 28 is a graph showing the dependence of saturation magnetization, coercive force and magnetic permeability on the thickness with respect to comparative samples having the composition Fe₇₈Si₉B₁₃ and obtained with and without heat treatment and samples having the composition Fe₇₃Al₅Ga₂P₁₁C₅B₄ and obtained with and without heat treatment;
Fig. 29 is a graph showing the dependence of saturation magnetization, coercive force and magnetic permeability on the thickness with respect to quenched ribbons having the composition Fe₇₂Al₅Ga₂P₁₀C₆B₄Si and obtained without heat treatment and after heat treatment;
Fig. 30 is a graph showing the dependence of saturation magnetization, coercive force and magnetic permeability on the thickness with respect to a comparative sample having the composition Fe₇₈Si₉B₁₃ and a sample having the composition Fe₇₂Al₅Ga₂P₁₀C₆B₄Si
Fig. 31 is a drawing showing a general circuit for measuring magneto-impedance characteristics
Fig. 32 is a drawing showing a conventional magnetic head, in which Fig. 32A is a plan view, and Fig. 32B is a front view; and
Fig. 33 is a graph showing the magnetic field sensitivity of an example of conventional MI elements.

### DESCRIPTION OF THE PREFERRED EMBODIMENT

The Fe-based glassy alloy which constitutes the MI element of the present invention is an amorphous material, and has a composition, for example, the following composition:

Fe₇₂Al₅Ga₂P₁₁C₆B₄ Example 1

For this Fe-based glassy alloy, DCS (Differential Scanning Calorimetry) measurement of the crystallization temperature (Tx) and the glass transition temperature (Tg) using a sample of 108 µm thick shows the following values:
Crystallization temperature = 506 °C
Glass transition temperature = 458 °C Therefore, the temperature width ΔTx of the supercooled liquid region expressed by the equation ΔTx = Tx - Tg is the following:
Temperature width ΔTx of supercooled liquid region = 48 °C Thus the temperature width is 35 °C or more.

When a ribbon-shaped sample formed by using the Fe-based glassy alloy is inserted as a magnetic material Mi into the measurement circuit schematically shown in Fig. 31, and an external magnetic field Hex is applied to the sample Mi in the length direction thereof with an alternating current Iac of 3 MHz applied, the output voltage (Eme), i.e., impedance, substantially symmetrically changes (increases) depending upon the absolute values of positive and negative magnetic fields with zero magnetic field as the center, as shown by Example 1 in Fig. I. This indicates that the sample has the magneto-impedance effect.

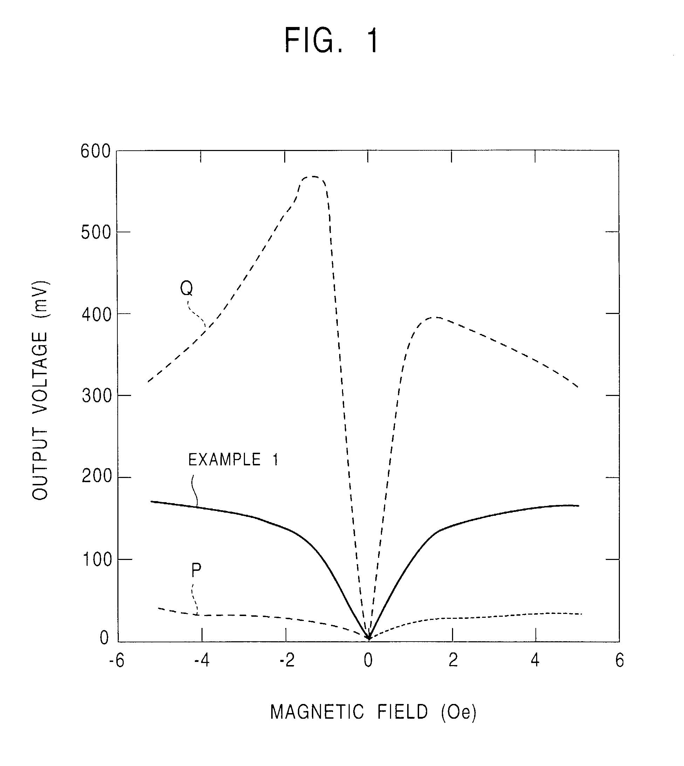

In comparison with the conventional examples of amorphous alloys shown in Fig. 1, i.e., (P) Fe₇₈Si₉B₁₃ and (Q) (Fe₆Co₉₄)_{72.5}Si_{12.5}B₁₅, which have previously been known to have the magneto-impedance effect, an MI element of Example 1 has higher sensitivity than (P) Fe₇₈Si₉B₁₃, and the amplification factor of a magnetic field sensing circuit comprising this MI element can be decreased, thereby suppressing noise. On the other hand, the MI element exhibits gentle rising and thus good quantitative performance in the weak magnetic field range of - 2 to + 2 Oe, as compared with (Q), and sensitivity has good symmetry with positive and negative magnetic fields. Therefore, a circuit configuration including an equalizer of a magnetic field sensing circuit can easily be formed. It is thus found that the MI element of Example 1 can be suitably used as the magnetic field sensing element.

The Fe-based glassy alloy used for the MI element of the present invention has soft magnetism at room temperature, and is thus advantageous for various applications to a magnetic head and the like. It was found that the soft magnetism is further improved by heat treatment in the temperature range of 300 to 500°C. Therefore, the MI element subjected to heat treatment is preferably used for some applications.

Next, the Fe-based glassy alloy which can be used for the MI element of the present invention will be described in detail.

The Fe-based glassy alloy used in the present invention basically contains Fe as a main component and has ΔTx of 35°C or more. Conventionally, Fe-based alloy compositions of Fe-P-C, Fe-P-B and Fe-Ni-Si-B types have been known to produce glass transition. However, these alloy compositions have a supercooled liquid region having a temperature width ΔTx of as small as 25°C or less, and an amorphous material can be obtained only by quenching. Therefore, only a thin film solid can be obtained, and it is difficult to obtain a formed product having a practical thickness. On the other hand, the Fe-based glassy alloy used in the present invention has ΔTx of 35°C or more, and forming can be carried out by slow cooling. Therefore, it is possible to form a relatively thick ribbon-shaped or filament-shaped product, and thus form a practical MI element.

In order to obtain the Fe-based glassy alloy having the high magneto-impedance effect and ΔTx of 35°C or more, a metal element other than Fe and a semimetal element are contained in the alloy.

The metal element other than Fe can be selected from the 3B and 4B groups in the periodic table, specifically, at least one selected from the group consisting of Al, Ga, In, Tl, Sn and Pb. Particularly, Al, Ga, In or Sn is preferable.

The semimetal element is at least one selected from the group consisting of P, C, B, Ge and Si. Particularly, the three elements of P, C and B are preferably contained.

The Fe-based glassy alloy may further contain at least one selected from the group consisting of Nb, Mo, Hf, Ta, W, Zr and Cr, and at least one selected from the group consisting of Ni and Co.

The Fe-based glassy alloy having particularly good characteristics for the MI element can be obtained from the following composition A:

| (Composition A) | |
|---|---|
| Element | Atomic % |
| Al | 1 to 10 |
| Ga | 0.5 to 4 |
| P | 9 to 15 |
| C | 5 to 7 |
| B | 2 to 10 |
| Si | 0 to 15 |
| Fe | balance |

The Fe-based glassy alloy used in the present invention may contain Ge in the range of 4 atomic % or less, and Nb, Mo, Hf, Ta, W, Zr and/or Cr in the range of 7 atomic % or less. The Fe-based glassy alloy may further contain Ni and/or Co in the range of 10 atomic % or less.

By adding Si, it is possible to improve the temperature width ΔTx of the supercooled liquid region, and increase the critical thickness of an amorphous single-phase texture. With an excessively high Si content, the supercooled liquid region disappears, and thus the Si content is preferably 15 atomic % or less. In order to obtain the effect of addition of Si, a Si content of 0.5 atomic % or more is more preferable.

Examples of the Fe-based glassy alloy having excellent characteristics for the MI element of the present invention are alloys having the following compositions:

Fe₇₂Al₅Ga₂P₁₁C₆B₄ Example 1

Fe₇₂Al₅Ga₂P₁₀C₆B₄Si Example 2

Fe₇₃Al₅Ga₂P₁₁C₅B₄ Example 3

Fe₇₀₊ₓAl₅Ga₂(P₅₅C₂₅B₂₀)₂₃₋ₓ (x =1 to 5) Example 4

(wherein the numerals in parentheses are by atomic % based on the total P+C+B of 100)

With all of the above compositions, a formed product of a Fe-based glassy alloy can be obtained by cooling a melt mixture of the elements under adjusted cooling conditions. Fe-based glassy alloys generally have the common property that a supercooled liquid region having a temperature width ΔTx is present between the crystallization temperature Tx and the glass transition temperature Tg. In this region, the past heat history of a Fe-based glassy alloy completely disappears, and the atoms in a composition is in an internal equilibrium state with high diffusivity. Therefore, in this state, the composition is not crystallized by quenching, but an amorphous material, i.e., a Fe-based glassy alloy, is obtained.

However, all conventional known amorphous alloys of Fe-P-C type, (Fe, CO, Ni)-P-B type, (Fe, Co, Ni)-Si-B type, (Fe, Co, Ni)-M (Zr, Hf, Nb) type, (Fe, Co, Ni)-M (Zr, Hf, Nb)-B type, and the like have no supercooled liquid region or a supercooled liquid region having a very narrow temperature width ΔTx, and thus an amorphous material can be obtained only by quenching at a cooling rate of 10⁵ °C/s by the single roll method or the like. The product obtained by quenching by the single roll method is a thin film having a thickness of about 50 µm or less, and it is difficult to obtain a ribbon- or filament-formed product which can be used as the magnetic field sensing element or the like.

Since the Fe-based glassy alloy used in the present invention has a supercooled liquid region having a temperature width ΔTx of 35 °C or more, unlike conventional known glassy alloys, an amorphous solid can be obtained without quenching. Of course, a thin film also can be formed by guenching by the single roll method, but an independent thick formed product such as a ribbon or filament can be formed by a casting method, a liquid cooling method or the like.

The single roll method is a method comprising mixing single powders of the elements of each of the compositions at a predetermined ratio, melting the powder mixture by a melting device such as a crucible or the like in an atmosphere of an inert gas such as Ar gas to form an alloy melt, and then quenching the melt by spraying it on a cooling metal roll which rotates to obtain a ribbon-shaped Fe-based glassy alloy solid. In this method, with the Fe-based glassy alloy composition used in the present invention, the cooling rate can be decreased due to the sufficient large temperature width ΔTx of the supercooled liquid region, as compared with conventional alloys, and a relatively thick ribbon-shaped amorphous solid can be obtained.

With the Fe-based glassy alloy composition used in the present invention, a slow cooling method such as an injection casting method comprising casting in a copper casting mold can also be performed by utilizing the property that the temperature width ΔTx of the supercooled liquid region is sufficiently large. Of course, general casting devices having various structures which are widely used can be used as a casting device, and a continuous casting device can also be used.

In order to produce a MI element filament by using the Fe-based glassy alloy composition of the present invention, for example, such a liquid cooling method as disclosed in Japanese Patent Unexamined Publication No. 4-323351 can be used. This method basically comprises melting the alloy composition, and continuously ejecting the melt into a cooling liquid layer to solidify the melt by cooling. Other examples of forming methods include a method (jet method) comprising jetting a cooling liquid layer, and a method (centrifugal method) comprising holding by centrifugal force.

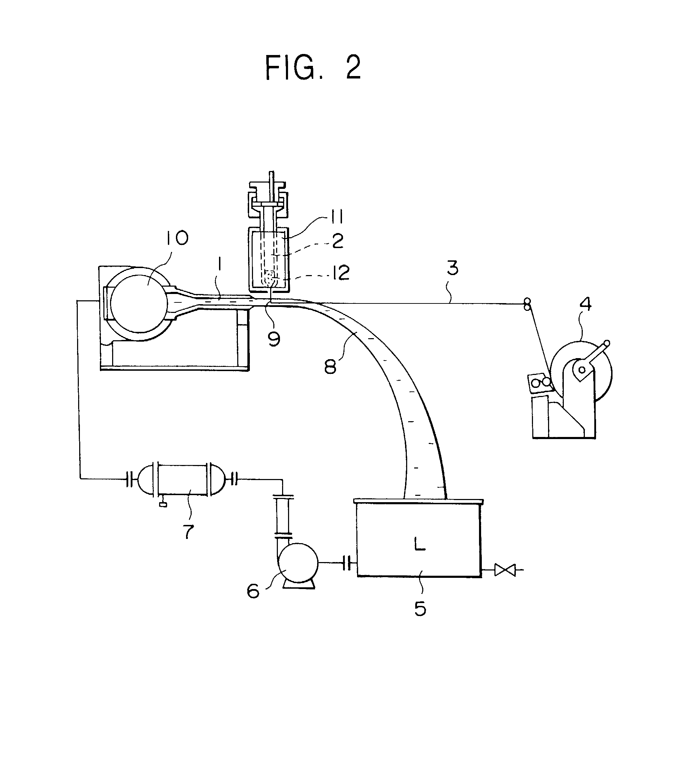

In the jet method of these methods, as schematically shown in Fig. 2, a cooling liquid L contained in a cooling liquid receiver tank 5 is pressed by a cooling liquid pressure pump 6, cooled to the predetermined temperature by a cooler 7 and then pressed to the predetermined pressure by a liquid pressure tank 10. Next, the pressed cooling liquid L is jetted from a cooling liquid exhaust nozzle 1 at the predetermined rate to form a jet 8 which is returned to the cooling liquid receiver tank 5. On the other hand, an alloy composition 12 is melted by a heating surface 11, sent to a melt alloy jetting device 2, and then jetted from the melt alloy jetting device 2 using argon gas pressure. The melt alloy jet 9 is solidified by cooling by the jet 8 of the cooling liquid jetted from the cooling liquid exhaust nozzle 1 to form a MI element filament 3. The thus-obtained MI element filament 3 is wound by a winder 4.

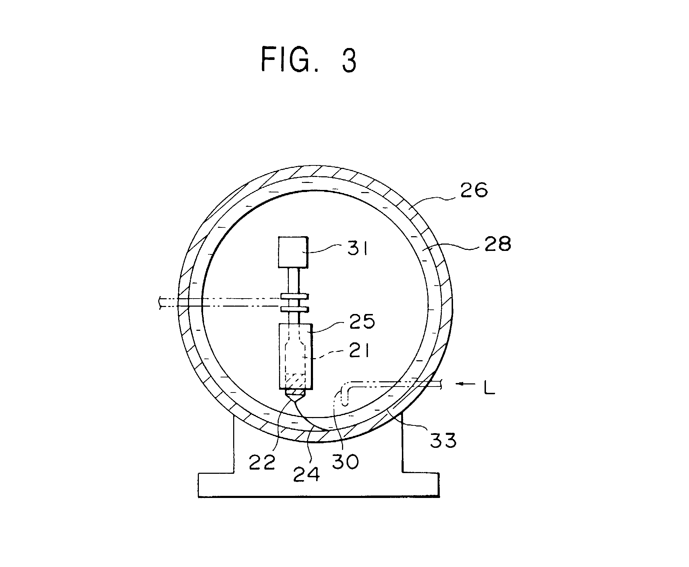

In the centrifugal method, as shown in Fig. 3, an alloy composition as a raw material is fed through a feeding port 31 of a crucible 21 by using argon gas, and melted by heating by a heating furnace 25. During this time, a rotating drum 26 is rotated at the predetermined rotational speed by a drive motor not shown in the drawing. Next, a cooling liquid L is supplied into the rotating drum 26 through a cooling liquid supply tube 30 to form a cooling liquid layer 28 by using centrifugal force. Next, the tip nozzle 22 of the crucible 21 is moved downward to approach the liquid surface of the cooling liquid layer 28, and the inside of the crucible 21 is pressurized to jet a melt composition 24 toward the liquid surface of the cooling liquid layer 28. Into the crucible 21 is constantly charged an inert gas for preventing oxidation of the raw material, to maintain an inert atmosphere. The alloy jetted toward the liquid surface of the cooling liquid layer 28 is solidified by cooling to form a MI element filament 33 which is moved in the cooling liquid layer 28 by the resultant force of force in the jet direction and the rotation direction of the rotating drum 26 and centrifugal force, and successively wound along the inner wall of the rotating drum 26. After spinning is completed, the tip of the tube 30 is inserted into the cooling liquid layer 28 to discharge the cooling liquid by suction. Then, the rotating drum 26 is stopped, and the MI element filament 33 accumulated on the inner wall of the rotating drum 26 is taken out.

Although the present invention is not limited to the theory below, the reason why the Fe-based glassy alloy used for forming the MI element of the present invention has the high ability to form an amorphous material is thought to be the following. Since the composition used in the present invention comprises a group of elements having large differences in atomic diameter and negative heat of mixing, the composition has a highly disordered packing structure in a liquid state, resulting in the synergistic effect of suppression of formation of crystal nuclei from a liquid phase due to high solid/liquid surface energy and formation of the disordered packing structure accompanied with difficulties in diffusion migration of atoms for a long distance required for forming a crystal phase.

Like general MI elements, the MI element of the present invention is soft magnetic and sensitive to a change in a magnetic field in the lengthwise direction of a glassy alloy formed product. Therefore, in formation of a coil of a magnetic sensor head by using the glassy ally, the coil is magnetized circumferentially by the flowing current, and a diamagnetic field due to a magnetic field in the lengthwise direction of the head is very small. Therefore, the length of the head can significantly be decreased, as compared with a conventional high-sensitivity flux detection type magnetic sensor such as a flux gate sensor or the like. It is also possible to form a magnetic sensor head having a rate of impedance change of several tens to 100 %/Oe, a high resolution of 10⁻⁶ Oe, a cutoff frequency of several MHz, high sensitivity and small dimensions. For example, even with a head length of 1 mm or less, the magnetic field sensing limit does not deteriorate, and the minimum sensing limit for an AC magnetic field of 1 Hz or more reaches 10⁻⁶. Therefore, for example, the surface magnetic field (about 0.1 Oe at a distance of about 2 mm from the surface) of a rotary encoder ring magnet having a diameter of 19 mm and 1000 poles (a magnetic distance of about 60 µm) can precisely be sensed at a distance of 1 mm or more. Also geomagnetism (about 0.3 Oe) can also be sensed.

The magnetic sensor head using the MI element of the present invention utilizes a change in magnetic flux due to rotation of magnetization with high responsivness and thus has high responsiveness. Namely, when the frequency of the current passing through the coil is increased, the impedance sensitively changes due to a skin effect, depending upon the external magnetic field to increase sensitivity, and a circumferential magnetic flux is generated only by rotation of a magnetization vector due to suppression of movement of domain walls by strong eddy current damping to increase responsiveness. When a self oscillation circuit such as a Colpitts oscillation circuit is formed by using the MI element of the present invention to form an amplitude modulation type sensor, the cutoff frequency is about 1/10 of the oscillation frequency, and magnetic fields ranging from a DC magnetic field to a high-frequency magnetic field of several MHz can stably be sensed at an oscillation frequency of several tens MHz and with a resolution of about 10⁻⁶ Oe. This has a response speed of 1000 times as high as the flux gate sensor which is a conventional high-sensitivity sensor. In order to sense magnetic information of a magnetic recording medium, it is essential for the magnetic head to have high responsiveness. For example, when a 2000-pole magnetization ring magnet having a diameter of 19 mm is rotated at a rate of 3600 rpm, in order to sense a basic wave of 120kHz and a higher harmonic of several times the basic wave, a cutoff frequency in the MHz level is required. Although the present cutoff frequency of VTR is 4.75 MHz, the cutoff frequency is supposed to become 50 MHz in future. The MI element of the present invention can comply with these requirements by setting the flowing current to 500 MHz or more.

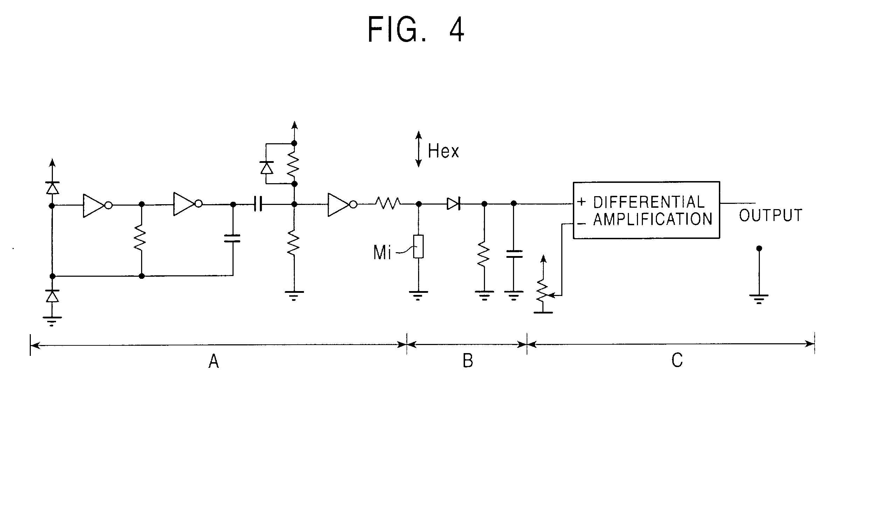

In formation of a weak magnetic field sensor using the MI element of the present invention, since a high-frequency current is used, care must be taken to prevent sensitivity from being made unstable by the floating impedance of the circuit. As a measure for solving this problem, it is preferable to use a self oscillation type magnetic field sensing circuit comprising a head (referred to as "the MI head" hereinafter) comprising the MI element of the present invention and a high-frequency power source, both of which are integrated. Fig. 4 shows an example of such a magnetic field sensing circuit having a self-oscillation circuit.

In the circuit shown in Fig. 4, blocks A, B and C correspond to a high-frequency power source, an external magnetic field (Hex) sensing unit, and an amplification output unit, respectively. MI head (Mi) is inserted into the external magnetic field sensing unit B.

The high-frequency power source A comprises a circuit for generating a high-frequency alternating current and supplying the alternating current to the external magnetic field sensing unit B, and the type thereof is not limited. An example of the high-frequency power source A utilizes a stabilized Colpitts oscillation circuit. In the self oscillation system, a magnetic field sensing operation can also be performed by applying amplitude modulation (AM), frequency modulation (FM) or phase modulation (PM), which utilizes magnetic modulation.

The external magnetic field sensing unit B comprises the MI element (Mi) and a demodulation circuit, wherein the MI element brought into a standby state by the high-frequency alternating current supplied from the high-frequency power source A responds to the external magnetic field (Hex) to generate an impedance change, which is demodulated by the demodulation circuit and then transmitted to the amplification output unit C.

The amplification output unit C comprises a differential amplification circuit and an output terminal. Although not shown in Fig. 4, the magnetic sensor circuit comprises a negative-feedback loop circuit to form a weak magnetic field sensor circuit having high precision, high sensitivity, high responsiveness and high stability by applying strong negative feedback.

The MI element of the present invention shows the same changes in parameters as those shown in Fig. 1 regardless of the polarity of the external magnetic field. Therefore, in order to form a linear magnetic field sensor, a DC magnetic field bias must be applied. Since the MI element exhibits high linearity in a weak magnetic field, a weak magnetic field bias may be applied, and, in fact, a method in which a coil is wound 10 to 20 turns around the MI head, for applying an alternating current of several mA, is suitable.

The MI head is provided with helical magnetic anisotropy by applying twisting stress to the MI element filament, and magnetized (excited) by an alternating current having a DC bias to obtain the asymmetric magneto-impedance effect with the external magnetic field (Hex). A linear magnetic field sensor can be formed by using a differential voltage between two MI filaments. This method is advantageous for the use of a long head, as in a current sensor.

The above-described MI element of the present invention having the above characteristics can be applied to a weak magnetic field sensor, a rapid-response current sensor, a weak magnetic direction sensor, a flux gate sensor, an electromagnetic wave sensor, a potentiometer, a rotary encoder head, an electronic compass, a magnetic head, a tablet, a magnetic-field test head, a magnetic card, a magnetic ticket head, a magnetic proximity switch, a magnetic flux memory, a magnetic neurone, an antenna core, a medical magnetic fluid monitor, etc.

An embodiment in which the above-described MI element is used as a magnetic head will be described with reference to the drawings.

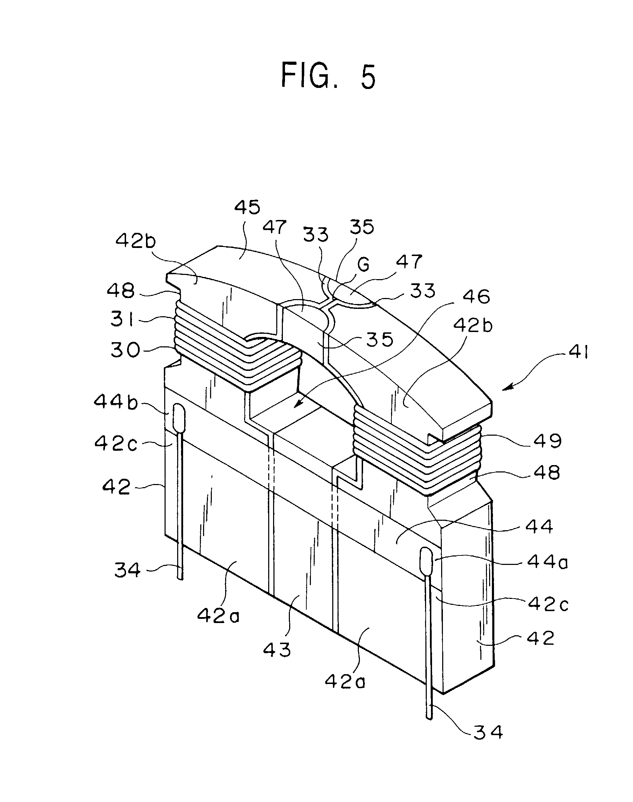

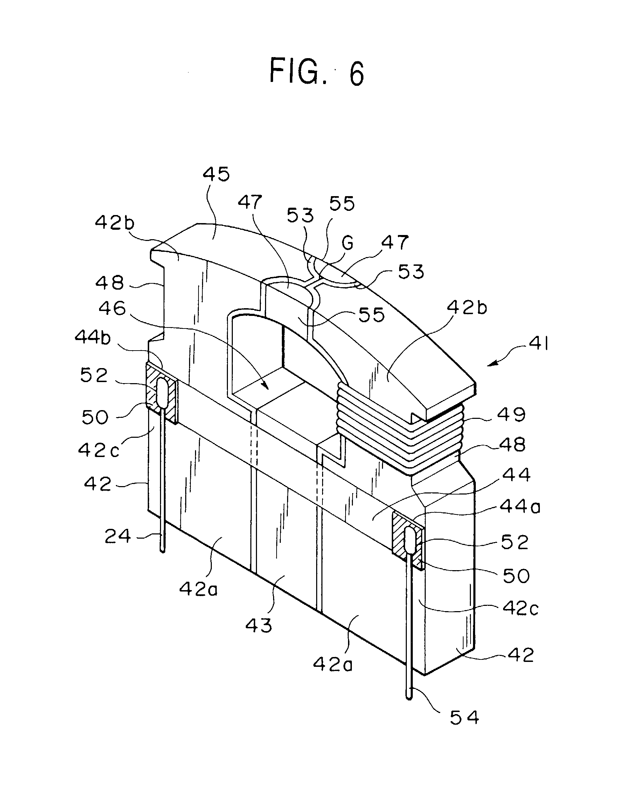

In Figs. 5 and 6, a magnetic head 41 comprises a pair of cores 42, junction glass 43 joined to the lower portions 42a of the pair of cores 42 to be held therebetween, and a thin film-shaped magneto-impedance effect element (MI element) 44 made of a magnetic material.

Also the magnetic head 41 comprises a sliding surface 45 on which a recording medium not shown in the drawings slides and which is formed by the upper surfaces of the upper portions 42b of the pair of cores 42, a magnetic gap G being provided at the center of the sliding surface 45.

In the magnetic head 41, the MI element 44 is arranged over the pair of cores 42 to be joined to the sides of the pair of cores 42 so that an external magnetic field due to recording magnetization of the recording medium is applied to the MI element 44 through the pair of cores 42.

Specifically, the lengthwise ends 44a and 44b of the MI element 44 are joined, by any desired means, to the magnetic path connecting surfaces 42c which are sides of the pair of cores 42.

In this way, a closed magnetic circuit is formed by the pair of cores 42, the MI element 44 and the magnetic gap G.

The junction glass 43 is made of a nonmagnetic material, and is adapted for joining the pair of cores 42 with a space therebetween. In the upper portions of the opposite sides of the cores 42 are respectively formed recesses, a winding hole 46 which is divided into parts respectively corresponding to the cores 42 and the glass 43 being formed between the recesses.

Each of the pair of cores 42 is made of ferrite which is an oxide ferromagnetic material. As ferrite, MnZn type polycrystalline ferrite, MnZn type single crystal ferrite, combined ferrite comprising Mn-Zn type single crystal ferrite and MnZn polycrystalline ferrite, MnZnSn type polycrystalline ferrite and the like have properties such as a high saturation magnetic flux density, high magnetic permeability, high electric resistance, low eddy current loss high hardness, excellent abrasion resistance, etc., and are thus optimum for a core of a magnetic head.

In the junction between the upper portions of the pair of cores 42 is provided a regulation groove 47 for regulating the track width of the magnetic gap G, the regulation groove 47 being filled with glass 35 which is a nonmagnetic material.

Further, on the outer sides of the upper portions of the pair of cores 42 are formed winding grooves 48 in one of which a recording coil 49 is wound.

The MI element 44 is made of the above-described Fe-based glassy alloy containing Fe as a main component. Although, in the example shown in the drawings, the MI element 44 comprises a thin film, or the MI element 44 may comprise a plurality of stranded wires given twist.

The magnetic head 41 further comprises bias applying means 30 for applying bias magnetization to the MI element 44.

An example of the bias applying means 30 is means in which a bias current is passed through the bias coil 31 wound in the winding groove 48 to apply a magnetic flux to the cores 42, and the magnetic flux is applied to the MI element through the cores 42 to generate bias magnetization, as shown in Fig. 5.

Another example of the bias applying means 30 is means in which permanent magnet layers (permanent magnets) 52 are provided at the ends 44a and 44b of the MI element so that magnetization of the permanent magnet layers 52 is applied to the MI element 44 to generate bias magnetization, as shown in Fig. 6.

As the permanent magnet layers 52, any hard magnetic material may be used, but Fe-Nd-B and Co-Cr-Pt type hard magnetic materials are preferable. Since these Fe-Nd-B and Co-Cr-Pt type hard magnetic materials have high remanent magnetization and coercive force, sufficient bias magnetization can be applied to the MI element 44 even if the volume of the permanent magnets 52 is decreased.

The permanent magnet layers 52 are deposited at the ends 44a and 44b of the MI element 44 by a deposition method such as sputtering or the like.

To each of the ends 44a and 44b of the MI element 44 are connected a lead 54 for outputting output signals, and a lead (not shown in the drawing) for applying an alternating current to the MI element 44.

Further, on each of the pair of cores 42 of the magnetic head 41 is formed a metal magnetic film 53 by a deposition method such as sputtering or the like, and on the metal magnetic film 53 is formed a gap layer not shown in the drawing by a deposition method such as sputtering or the like to form the MIG (Metal In Gap) type magnetic head.

For the metal magnetic films 53, a soft magnetic alloy having higher magnetic permeability than ferrite is used, and particularly, an Fe-Si-Al system alloy, a Fe-Ni system alloy and an amorphous alloy and the like are preferable.

For the gap layers, a nonmagnetic material such as SiO₂, Al₂O₃, CrSiO₂ or the like is used.

As described above, the Fe-based glassy alloy which constitutes the MI element 44 is formed by the single roll method, the jet method or the centrifugal method, and exhibits a supercooled liquid region having a temperature width ΔTx of 20°C or more, which is a significant value of 40 to 60°C with some compositions, and which is expressed by the equation ΔTx = Tx - Tg (wherein Tx is the crystallization temperature, and Tg is the glass transition temperature). Therefore, forming can be performed by slow cooling, and a relatively thick ribbon- or filament-shaped product can be formed. Also a stable amorphous alloy can be obtained.

In the MI element 44 formed by using the Fe-based glassy alloy, when an external magnetic field is applied in the length direction of the MI element 44 with an alternating current in the MHz band applied, the output voltage, i.e., impedance, changes (rises) symmetrically in the positive and negative directions depending upon the absolute values of the positive and negative magnetic fields with zero external magnetic field as the center. Namely, the so-called magneto-impedance effect is exhibited.

The magnetic head 41 has the closed magnetic circuit formed by the pair of cores 42, the MI element 44 comprising the Fe-based glassy alloy and the magnetic gap G, and when an alternating current is passed through the MI element 44, the impedance of the MI element 44 sensitively changes depending upon a change in the magnetic flux of the external magnetic field applied from a recording medium through the cores 42, thereby making the magnetic head 41 highly sensitive.

Also the movement of magnetic domains of the MI element 44 is suppressed by strong eddy current damping, and a circumferential magnetic flux is generated only by rotation of a magnetization vector, thereby improving the responsiveness of the magnetic head 41.

The high responsiveness of the magnetic head 41 is an essential requirement for sensing magnetic information of a magnetic recording medium or the like. For example, when a 2000-pole magnetization ring magnet having a diameter of 19 mm is rotated at a rate of 3600 rpm, in order to sense a basic wave of 120 kHz and a higher harmonic of several times the basic wave, a cutoff frequency at the MHz level is required. Although the present cutoff frequency of VTR is 4.75 MHz, the cutoff frequency is supposed to become 50 MHz in future. The magnetic head 41 comprising the MI element 44 of the present invention can comply with these requirements by setting the flowing current to 500 MHz or more.

When the magnetic head 41 comprising the MI element 44 of the present invention is combined with a self-oscillation circuit such as a Colpitts oscillation circuit to form an amplitude modulation type magnetic head, a magnetic field ranging from a DC magnetic field to a high-frequency magnetic field of several MHz can be stably sensed at an oscillation frequency of several tens MHz with high sensitivity of resolution of about 10⁻⁶ Oe. It is thus possible to sense record magnetization of a recording medium on which magnetic information is recorded at a high density.

The MI element 44 of the present invention exhibits symmetrical changes in impedance with zero external magnetic field as the center regardless of the polarity of the external magnetic field. Therefore, in order to use for a magnetic head, a DC magnetic field bias must be applied, but the bias magnetic field may be weak because the MI element 44 of the present invention has light linearity in a weak magnetic field.

Therefore, in the case of the bias applying means 50 in which a bias current is passed through the bias coil 51 a DC current of several mA may be applied, and thus the circuit configuration of the bias applying means 50 can be simplified.

In the case of the permanent magnets 52 provided at the ends 44a and 44b of the MI element 44, low magnetization is sufficient for the permanent magnets 52, and thus the volume of the permanent magnets 52 can be decreased, thereby realizing a decrease in size of the magnetic head 41.

Since the pair of cores 42 are made of ferrite and are capable of applying record magnetization of the recording medium to the MI element 44 without a loss, high sensitivity of the magnetic head 41 can be achieved. Also a core having a complicated shape can easily be formed because ferrite has excellent workability.

In addition, since the recording coil 49 is wound on the magnetic head 41, record magnetization can be written on the magnetic recording medium, and a reproduction/recording magnetic head can thus be formed by combination with the MI element 44.

Next, a thin film magnetic head in accordance with an embodiment of the present invention is described with reference to the drawings.

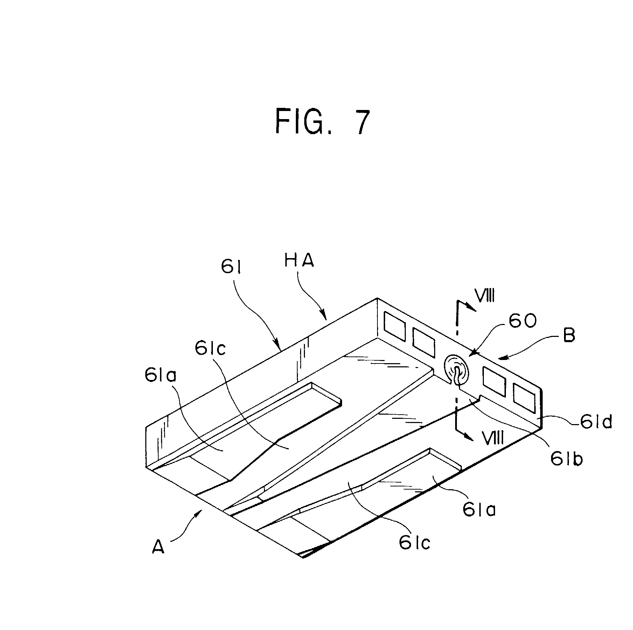

The thin film magnetic head HA of this embodiment shown in Fig. 7 is a floating type that is loaded on a hard disk or the like. In the slider 61 of the magnetic head HA, side A shown in Fig. 7 is the leading side on the upstream side in the direction of movement of the disk surface, and side B shown in Fig. 7 is the trailing side. On the surface of the slider 61 opposite to the disk are formed rail surfaces 61a and 61b, and air grooves 61c.

On the end surface 61d of the slider 61 on the trailing side thereof is provided a thin film magnetic head core 60.

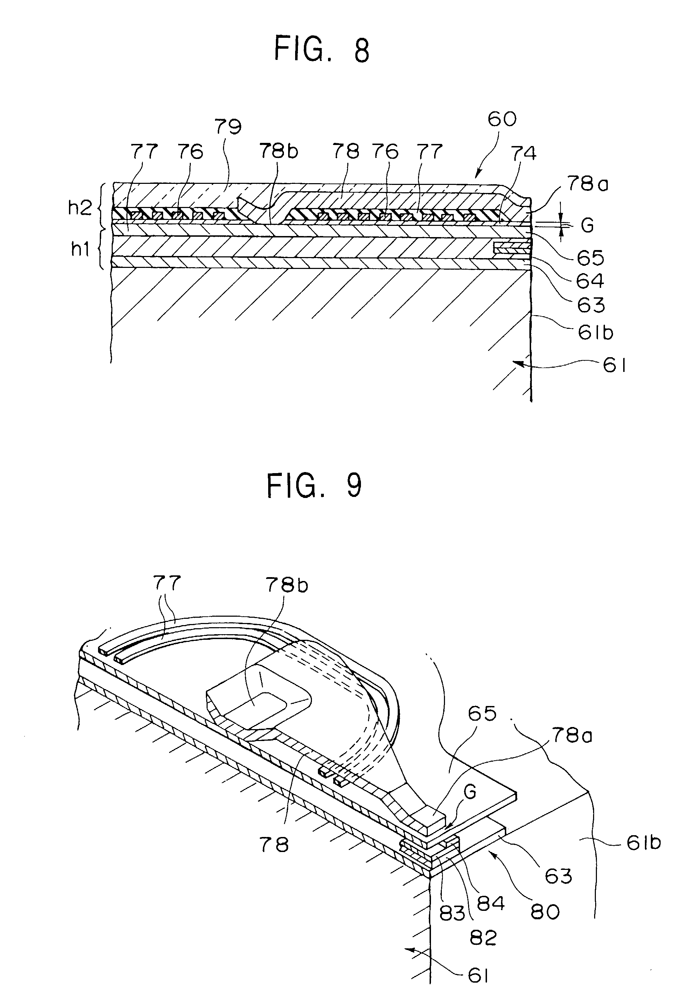

The thin film magnetic head core 60 of this embodiment is a combination magnetic head having the sectional structures shown in Figs. 8 and 9, and comprises a MI effect element head (reading head) h₁ and an inductive head (magnetic induction type magnetic head: writing head) h₂, both of which are laminated in turn on the trailing end surface 61d of the slider 61.

In this embodiment, the MI effect element head h₁ is adapted for sensing a leakage magnetic flux from a recording medium such as a magnetic disk or the like by utilizing the MI effect to read magnetic signals.

As shown in Fig. 8, in the MI effect element head h₁, an upper gap layer 64 made of a nonmagnetic material such as aluminum oxide (Al₂O₃) is laminated on a lower gap layer 63 formed at the trailing-side end of the slider 61 and made of a magnetic alloy such as Sendust (Fe-Al-Si system alloys) or the like.

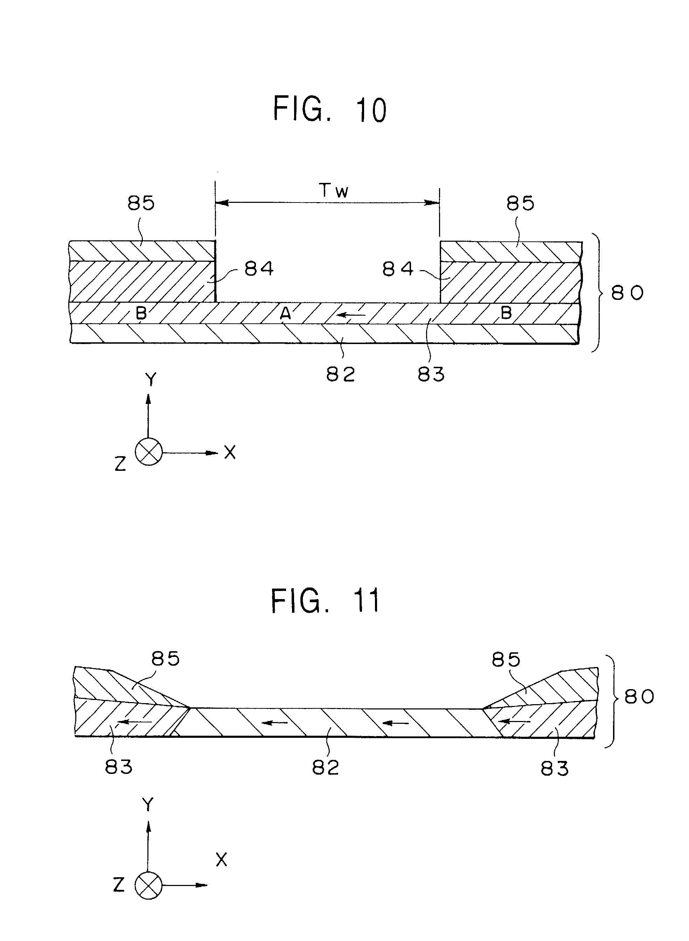

On the upper gap layer 64 is formed a MI effect element 80 having the sectional structure shown in Fig. 10, which will be described below.

The upper gap layer 64 made of aluminum oxide or the like is also continuously formed on the MI effect element 80 so as to cover the MI effect element 80, and an upper shielding layer is formed on the upper gap layer 64. The upper shielding layer is also used as a lower core 65 of the inductive head h₂ provided on the upper gap layer 64.

Fig. 10 shows an example of the MI effect element 80 applied to the MI effect element head h₁. The MI effect element 80 of this example comprises a MI effect element thin film 82 made of the above-described glassy alloy, a ferromagnetic thin film 83 laminated on the MI effect element thin film 82, antiferromagnetic thin films 84 laminated at both ends of the ferromagnetic thin film 83 with a distance T_{w} therebetween corresponding to the track width, and electrode films 85 respectively laminated on the antiferromagnetic thin films 84.

The ferromagnetic thin film 83 comprises a thin film of a Ni-Fe alloy, a Co-Fe alloy, a Ni-Co alloy, Co, a Ni-Fe-Co alloy or the like. The ferromagnetic thin film 83 may comprise a laminated structure composed of a Co thin film and a Ni-Fe alloy thin film.

Each of the antiferromagnetic thin films 84 is preferably made of FeMn, NiO, Cr-Al or a X-Mn alloy having a disordered structure. In the above composition formula, X is preferably at least one of Ru, Rh, Ir, Pd and Pt.

With the antiferromagnetic thin film 84 of one of the above alloys, a bias due to an exchange coupling magnetic field can be applied to the MI effect element thin film 82 which contacts the ferromagnetic thin film 83.

On the other hand, the inductive head h₂ of this embodiment comprises a gap layer 74 formed on the lower core 65, a coil layer 76 formed on the gap layer 74 to be patterned to a spiral form in a plane, the coil layer 76 being surrounded by an insulation material layer 77.

Further, an upper core layer 78 is formed on the insulation material layer 77 so that the tip end 78a is opposed to the layered lower core 65 with a small gap therebetween on the rail surface 61b to form the magnetic gap G, the base end 78b of the upper core 78 being magnetically connected to the lower core 65. On the upper core 78 is provided a protecting layer 79 made of aluminum oxide or the like.

In the inductive head h₂, a recording current is applied to the coil layer 76, and then applied to the core layer from the coil layer 76. A magnetic signal can be recorded on the recording medium such as a hard disk or the like by a leakage magnetic field between the tips of the lower core 65 and the upper core 78 in the magnetic gap G.

In the MI effect element head h₁, since the impedance of the MI effect element thin film 82 changes with a small leakage magnetic field from the magnetic recording medium such as a hard disk or the like, recording contents of the recording medium can be read by reading the change in impedance.

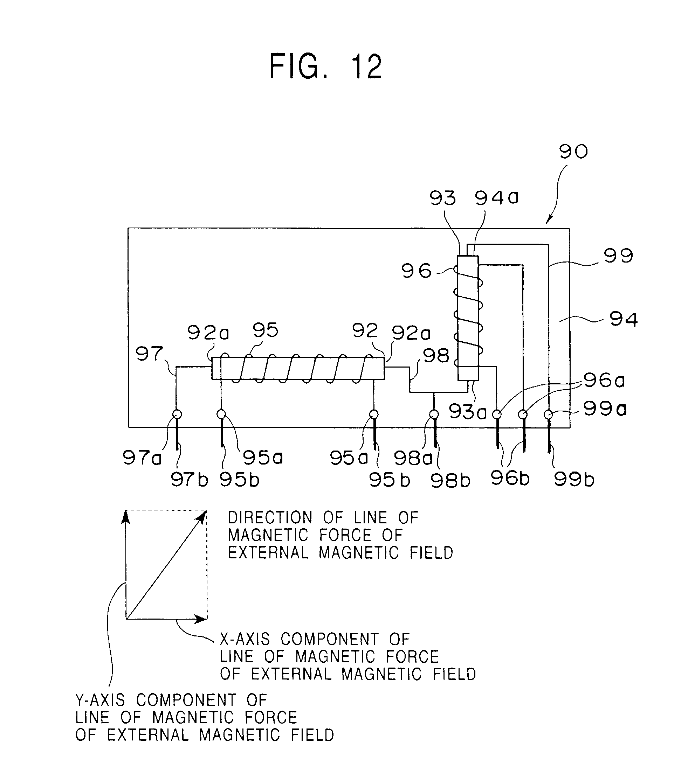

Fig. 11 shows a MI effect element thin film in accordance with another embodiment of the present invention. The structure of this embodiment comprises magnet layers (permanent magnet) 83 arranged on both sides of the MI effect element thin film 82 made of a glassy alloy, and electrode films 85 respectively laminated on the magnet layers 83 so that a bias is applied to the MI effect element thin film 82 by utilizing a leakage magnetic flux from the magnet layers 83.

Each of the magnet layers 83 used comprises a layer of a hard magnetic material (magnet material) such as a Co-Pt system or Co-Cr-Pt system alloy or the like.

In the structure shown in Fig. 11, like in the above embodiment, a bias can be applied, and magnetic information of a magnetic recording medium can be read by utilizing the MI effect.

The thin film magnetic head HA comprising the MI effect element thin film of the present invention is sensitive to a change in a magnetic field in the length direction (the direction X shown in Fig. 4) of the MI effect element thin film 82 made of a glassy alloy. It is also possible to form a thin film magnetic head having a rate of impedance change of several tens to 100 %/Oe, a high resolution of 10⁻⁶ Oe, a cutoff frequency of several MHz, and high sensitivity. For example, with a small head length, magnetic field sensitivity does not deteriorate, and the minimum sensing limit for an AC magnetic field of 1 KHz or more reaches 10⁻⁶.

The thin film magnetic head HA of this embodiment has high responsiveness because it utilizes a change in magnetic flux due to rotation of magnetization with high responsiveness. Namely, with a high-frequency flowing current, the impedance sensitively changes with an external magnetic field due to the skin effect to achieve high sensitivity, and a magnetic flux is generated by movement of a magnetization vector due to suppression of movement of the domain walls by strong eddy current damping to achieve high responsiveness. When a self-oscillation circuit such as a Colpitts oscillation circuit is formed by using the MI effect element thin film 82 of the present invention to form an amplitude modulation type sensor, the cutoff frequency is about 1/10 of the oscillation frequency, and a magnetic field ranging from a DC magnetic field to a high-frequency magnetic field of several MHz can stably be sensed at an oscillation frequency of several tens MHz with high sensitivity of a resolution of about 10⁻⁶ Oe. It is thus possible to provide a thin film magnetic head capable of sensing a small magnetic field from a magnetic recording medium with high sensitivity.

Next, an electronic compass in accordance with a further embodiment of the present invention will be described with reference to the drawings.

Referring to Fig. 12, an electronic compass 90 comprises a first magneto-impedance effect element (referred to as "the MI element" hereinafter) 92 serving as means for sensing a X-axis component of an external magnetic field, and a second MI element 93 serving as means for sensing a Y-axis component of the external magnetic field perpendicular to the X-axis.

Each of the first and second MI elements 92 and 93 are made of the Fe-based glassy alloy containing Fe as a main component, and has a shape having a substantially rectangular plane form and a predetermined thickness.

The first and second MI elements 92 and 93 are arranged on a plane 94 so that the directions of the current paths of the alternating currents respectively applied thereto are perpendicular to each other. Namely, the first and second MI elements 92 and 93 are arranged so that the length directions thereof are perpendicular to each other.

Specifically, the first and second MI elements 92 and 93 are fixed on the plane 94 by any desired means.

Although the first and second MI elements 92 and 93 shown in Fig. 12 have a plate-like shape, these MI elements are not limited to this, and a rod shape, a ribbon shape, a wire shape, a linear shape, a plurality of stranded linear products, or the like may be used.

On the first and second MI elements 92 and 93 are wound coils 95 and 96, respectively, for applying bias magnetization along the directions of the current paths of the alternating currents applied to the first and second MI elements 92 and 93, i.e., the lengthwise directions of the first and second MI elements 92 and 93.

Both ends of the coils 95 and 96 are connected to external coil leads 95b and 96b through coil terminals 95a and 96a, respectively.

To the both ends of the first and second MI elements 92 and 93 in the lengthwise directions thereof are connected output leads 97, 98 and 99 for outputting output currents.

The leads 97 and 99 are connected to output external leads 97b and 99b through output terminals 97a and 99a, respectively.

Both ends of the lead 98 are connected to the end 92a of the first MI element 92 and the end 93a of the second MI element 93. Also the lead 98 is connected to an output external lead 98b through an output terminal 98a.

Further, to both ends 92a and 93a of the first and second MI elements 92 and 93 in the lengthwise directions thereof are respectively connected leads for applying alternating currents (not shown in the drawing).

The operation of the electronic compass 90 is as follows. In Fig. 12, alternating currents in the MHz band are respectively applied to the first and second MI elements 92 and 93 through the leads not shown. At this time, a voltage is generated at both ends 92a or 93a of each of the first and second MI elements 92 and 93 due to the inherent impedance of each of the elements.

As shown in Fig. 12, when lines of magnetic force of an external magnetic field in any desired direction is applied to the first MI element 92, the impedance generated at both ends of the first MI element 92 corresponds to the magnitude of the component (X-axis component) of the lines of magnetic force parallel to the lengthwise direction of the first MI element 92.

Similarly, when the lines of magnetic force are applied to the second MI element 93, the impedance generated at both ends of the second MI element 93 corresponds to the magnitude of the component (Y-axis component) of the lines of magnetic force parallel to the lengthwise direction of the second MI element 93.

Namely, for the first and second MI elements 92 and 93, the impedance of each of the first and second MI elements 92 and 93 changes with a change in the direction of the lines of magnetic force due to the external magnetic field, resulting in a change in the voltage value output from each of the first and second MI elements 92 and 93.

In this way, in the electronic compass 90, an output current indicating a voltage value corresponding to the magnitude of the X-axis component of geomagnetism is output from the output terminals 97a and 98a, and an output current indicating a voltage value corresponding to the magnitude of the Y-axis component of geomagnetism is output from the output terminals 99a and 98a.

These output currents are sent to a processing unit not shown in the drawing through the external output leads 97b, 98b and 99b. In the processing unit, the direction of the lines of magnetic force due to geomagnetism is measured on the basis of the output currents obtained.

Although a conventional MR element has magnetic field sensitivity of about 0.1 Oe, an element (MI element) having the magneto-impedance effect is capable of sensing magnetism of about 10⁻⁵ Oe.

Particularly, when a self-oscillation circuit such as a Colpitts oscillation circuit or the like is connected to each of the first and second MI elements 92 and 93 of the present invention to apply an alternating current of several to several tens MHz, an external magnetic field can stably be sensed with resolution of about 10⁻⁶ Oe, and thus a weak external magnetic field can be sensed.

Therefore, even in a case in which each of the first and second MI elements 92 and 93 has a shape having a length decreased to decrease the inherent impedance of each of the MI elements, good sensitivity to magnetism can be obtained, and thus the size of the electronic compass 90 can be decreased.

Also as described above, the electronic compass 90 comprises the coils 95 and 96 for applying bias magnetization to the first and second MI elements 92 and 93, respectively.

As shown in 13A, each of the first and second MI elements 92 and 93 of the present invention exhibits substantially symmetrical changes in output voltages (impedance change) in the positive and negative directions depending upon the absolute value of an external magnetic field with zero external magnetic field as the center.

With no bias magnetization applied to each of the first and second MI elements 92 and 93 of the electronic compass 90, as shown in Fig. 13B, the output voltage from the first MI element 92 is decreased by changing the direction of the lines of magnetic force due to an external magnetic field by 0 to 90° with respect to the lengthwise direction of the first MI element 92. Also the output voltage from the first MI element 92 is increased by changing the direction of the lines of magnetic force due to an external magnetic field by 90 to 180°.

In this case, the values of the output voltages at 0° and 180° are the same, and thus the direction of the lines of magnetic force cannot be precisely measured.

With the bias magnetization applied to each of the first and second MI elements 92 and 93, as shown in Fig. 13C, the region where impedance linearly changes with the external magnetic field is used, and even if the direction of the lines of magnetic force due to an external magnetic field is changed by 0 to 180°, the output voltage of each of the MI elements linearly changes, and thus the direction of the external magnetic field can precisely be measured.

The absolute value of the magnitude of the bias magnetization applied to each of the first and second MI elements 92 and 93 is preferably in the range of 0.1 to 2 Oe. In the range of the absolute value of bias magnetization of 0.1 Oe or less or 2 Oe or more, the impedance does not linearly change with the external magnetic field.

Therefore, as the bias current applied to each of the coils 95 and 96 for applying bias magnetization, a DC current of several mA is sufficient.

Next, an autocanceller comprising the electronic compass serving as a magnetic sensor in accordance with a further embodiment is described with reference to the drawings.

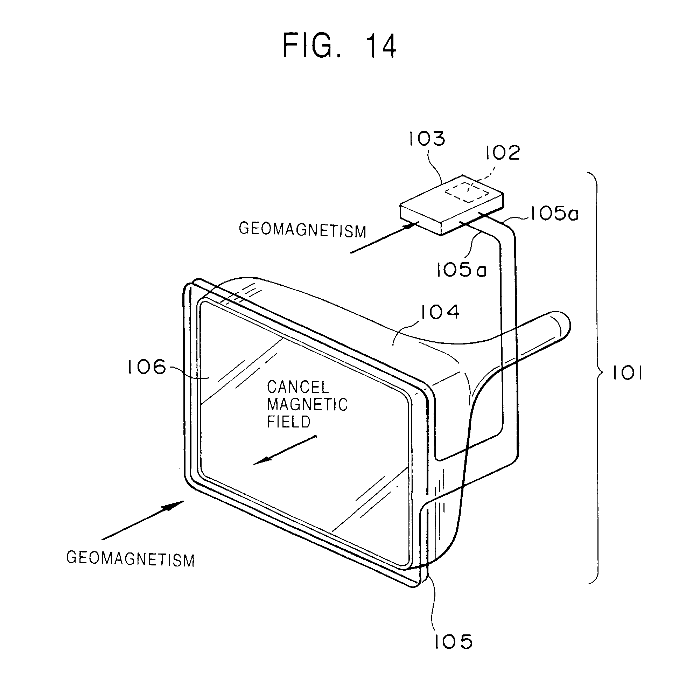

In Figs. 12 and 14, an autocanceller 101 comprises a cancel coil 105 comprising a coil wound around the periphery of a face (screen) 106 of a cathode ray tube 104, for applying a cancel magnetic field of magnitude equivalent to an external magnetic field in the direction opposite to the lines of magnetic force of the external magnetic field, and a control unit 103 for controlling the magnitude of the cancel magnetic field based on the direction of the lines of magnetic force of the external magnetic field detected by a magnetic sensor 102 comprising the electronic compass 90 shown in Fig. 12.

Both ends 105a of the cancel coil 105 are connected to the control unit 103.

The operation of the autocanceller 101 is as follows. In Fig. 14, to each of the first and second MI elements 92 and 93 of the electronic compass 90 (the magnetic sensor 102) is applied an alternating current in the MHz band from a lead not shown in the drawing. At this time, a voltage due to the inherent impedance of each of the elements is generated at both ends 92a or 93a of each of the first and second MI elements 92 and 93.

As shown in Fig. 14, when the lines of magnetic force of an external magnetic field such as geomagnetism in any desired direction is applied to the first MI element 92, the impedance generated at both ends of the first MI element 92 corresponds to the magnitude of the component (X-axis component) of the lines of magnetic force parallel to the lengthwise direction of the first MI element 92.

Similarly, when the lines of magnetic force is applied to the second MI element 93, the impedance generated at both ends of the second MI element 93 corresponds to the magnitude of the component (Y-axis component) of the lines of magnetic force parallel to the lengthwise direction of the second MI element 93.

Namely, for the first and second MI elements 92 and 93, the impedance of each of the first and second MI elements 92 and 93 changes with a change in the lines of magnetic force of geomagnetism, resulting in a change in the voltage value output from each of the first and second MI elements 92 and 93.

In this way, in the magnetic sensor 102, an output current indicating a voltage value corresponding to the magnitude of the X-axis component of geomagnetism is output from the output terminals 97a and 98a, and an output current indicating a voltage value corresponding to the magnitude of the Y-axis component of geomagnetism is output from the output terminals 99a and 98a.

These output currents are sent to a processing unit not shown in the drawing in the control unit 103 through the external output leads 97b, 98b and 99b. In the processing unit, the direction of the lines of magnetic force due to geomagnetism is measured on the basis of the output currents obtained.

Further, in the control unit 103, since the magnitude of geomagnetism is substantially constant on the earth, the magnitude of the component of the lines of magnetic force due to geomagnetism in the direction perpendicular to the face (screen) 106 of the cathode ray tube 104 is measured on the basis of the direction of the lines of magnetic force of geomagnetism sensed by the magnetic sensor 102.

A current corresponding to the magnitude of geomagnetism is applied to the cancel coil 105 from the control unit 103 to generate the cancel magnetic field having magnitude equivalent to geomagnetism in the direction opposite to the lines of magnetic force of geomagnetism. As a result, the lines of magnetic force due to geomagnetism are cancelled to remove the influence of the cathode ray tube 104 on an electron beam, thereby correcting movement of an image and color unevenness due to deterioration in color purity.

Although a conventional MR element has magnetic field sensitivity of about 0.1 Oe, an element (MI element) comprising the Fe-based glassy alloy and having the magneto-impedance effect is capable of sensing magnetism of about 10⁻⁵ Oe.

Particularly, when a self-oscillation circuit such as a Colpitts oscillation circuit or the like is connected to each of the first and second MI elements 92 and 93 of the present invention to apply an alternating current of several to several tens MHz, an external magnetic field can stably be sensed with resolution of about 10⁻⁶ Oe, and thus a weak external magnetic field can be sensed.

Therefore, even in a case in which each of the first and second MI elements 92 and 93 has a shape having a length decreased to decrease the inherent impedance of each of the MI elements, good sensitivity to magnetism can be obtained, and thus the size of the autocanceller 101 can be decreased.

As described above, the magnetic sensor 102 of the autocanceller 101 comprises the coils 95 and 96 for applying bias magnetization to the first and second MI elements 92 and 93, respectively.

### EXAMPLES

The present invention will be described in further detail below with reference to examples.

### EXAMPLE 1

### Production of MI element:

Predetermined amounts of Fe, Al, Ga, a Fe-C alloy, a Fe-P alloy and B were weighed and mixed, and the resultant mixture containing these raw materials was melted by a high-frequency induction heating furnace in an Ar atmosphere under reduced pressure to produce an ingot having the composition Fe₇₂A₅Ga₂P₁₁C₆B₄. This ingot was melted in a crucible and quenched by the single roll method in which the melt was sprayed on a rotating roll from the nozzle of the crucible in an Ar atmosphere under reduced pressure to obtain a quenched ribbon having a thickness of 20 µm. A sample of 31 mm long and 0.1 to 0.2 mm wide was cut off from the thus-obtained ribbon to form a MI element of Example 1.

### Measurement of MI element:

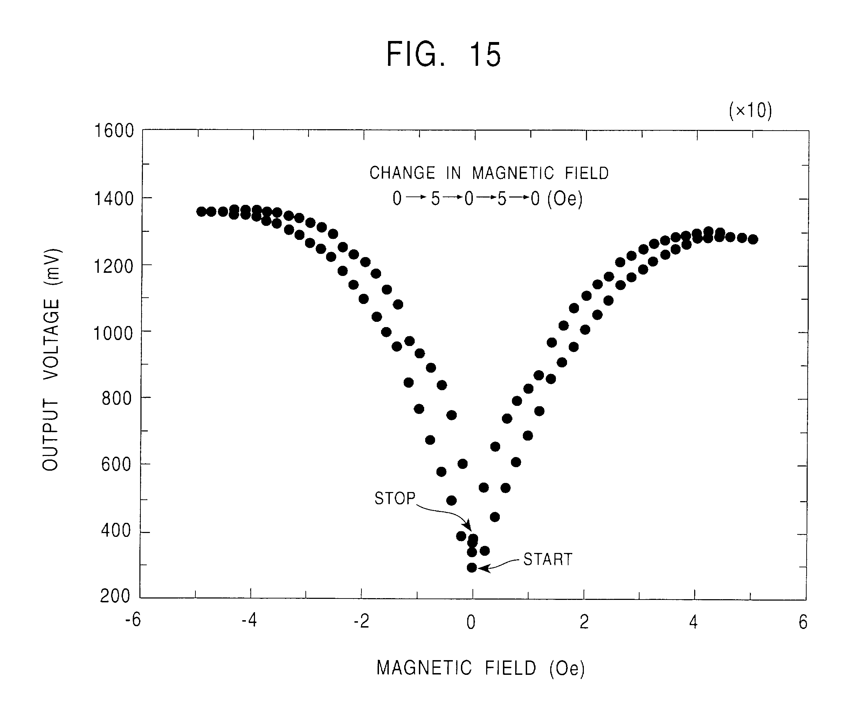

The MI element of Example 1 was inserted into the magnetic field sensing circuit shown in Fig. 4, and an external magnetic field Hex was applied to the sample in the length direction thereof with an alternating current of 3 MHz applied. The relation between the external magnetic field Hex (Oe) and the generated output voltage (mV) was plotted. The external magnetic field Hex was continuously changed from 0 Oe to 50 Oe, 0 Oe, - 50 Oe and 0 Oe. The amplification factor was set to 10 times. The results of measurement are shown in Fig. 15.

The results indicate that the MI element of Example 1 exhibits high sensitivity and good quantitative performance even in the weak magnetic field band of about - 2 to + 2 Oe.

### EXAMPLE 2

### Production of MI element:

Predetermined amounts of Fe, Al, Ga, a Fe-C alloy, a Fe-P alloy, B and Si were weighed and mixed, and the resultant mixture containing these raw materials was melted by a high-frequency induction heating furnace in an Ar atmosphere under reduced pressure to produce an ingot having the composition Fe₇₂A₅Ga₂P₁₀C₆B₄Si. This ingot was processed by the same method as Example 1 to obtain an MI element of Example 2 of 31 mm long, 0.1 to 0.2 mm wide and 20 µm thick.

### Measurement of MI element:

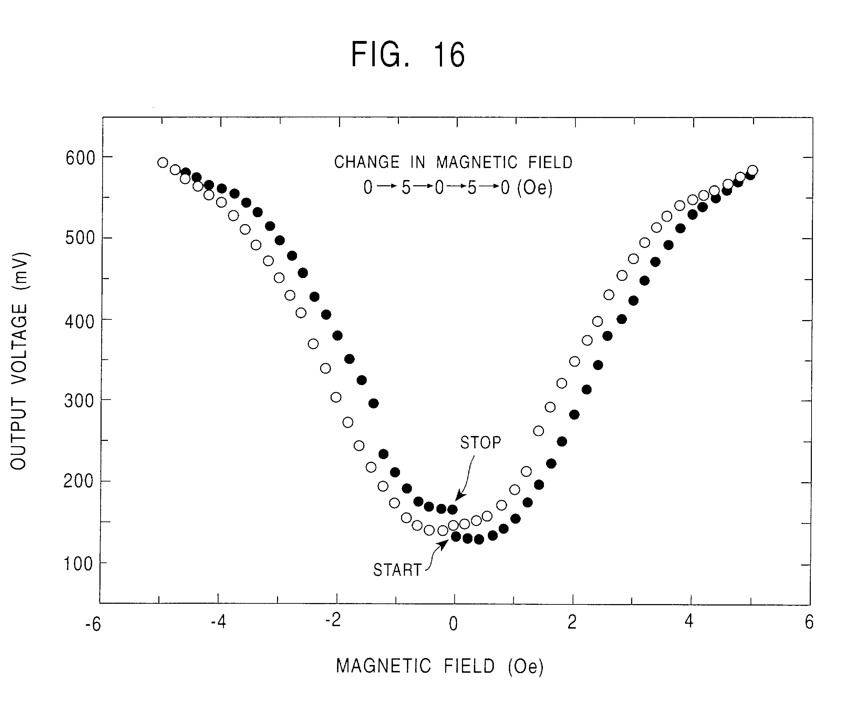

Like in Example 1, the MI element of Example 2 was inserted into the magnetic field sensing circuit shown in Fig. 4, and an external magnetic field Hex was applied to the sample in the length direction thereof with the alternating current of 3 MHz applied. The relation between the external magnetic field Hex (Oe) and the generated output voltage (mV) was plotted. The external magnetic field Hex was continuously changed from 0 Oe to 50 Oe, 0 Oe, - 50 Oe and 0 Oe. The amplification factor was set to 10 times. The results of measurement are shown in Fig. 16.

The results indicate that the MI element of Example 2 exhibits high sensitivity and good quantitative performance even in the weak magnetic field band of about - 2 to + 2 Oe.

### EXAMPLE 3

### Fe-Al-Ga-P-C-B type glassy alloy:

Predetermined amounts of Fe, Al, Ga, a Fe-C alloy, a Fe-P alloy and B were weighed and mixed, and the resultant mixture containing these raw materials was melted by a high-frequency induction heating furnace in an Ar atmosphere under reduced pressure to produce an ingot having the composition Fe₇₃A₅Ga₂P₁₁C₅B₄. This ingot was melted in a crucible and then quenched by the single roll method in an Ar atmosphere under reduced pressure to obtain a quenched ribbon. In production of the ribbon, the nozzle diameter, the gap between the nozzle tip and the roll surface, the rotational speed of the roll, the injection pressure, and the atmospheric pressure were set as shown in Table 1 to obtain ribbon-shaped Fe-based glassy alloy samples having a thickness of 35 to 229 µm.

**Table 1**

| Thickness (µm) | Nozzle diameter (mm) | Gap (mm) | Rotational speed (r.p.m) | Injection pressure (kgf/cm²) | Atmospheric pressure (cmHg) |
|---|---|---|---|---|---|
| 108 | 0.42 | 0.3 | 500 | 0.35 | -10 |
| 151 | 0.42 | 0.3 | 350 | 0.35 | -10 |
| 66 | 0.42 | 0.3 | 800 | 0.35 | -10 |
| 124 | 0.41 | 0.3 | 400 | 0.30 | -10 |
| 125 | 0.41 | 0.3 | 400 | 0.30 | -10 |
| 35 | 0.42 | 0.3 | 1500 | 0.35 | -10 |
| 180 | 0.42 | 0.3 | 250 | 0.30 | -10 |
| 229 | 0.42 | 0.6 | 250 | 0.40 | -10 |

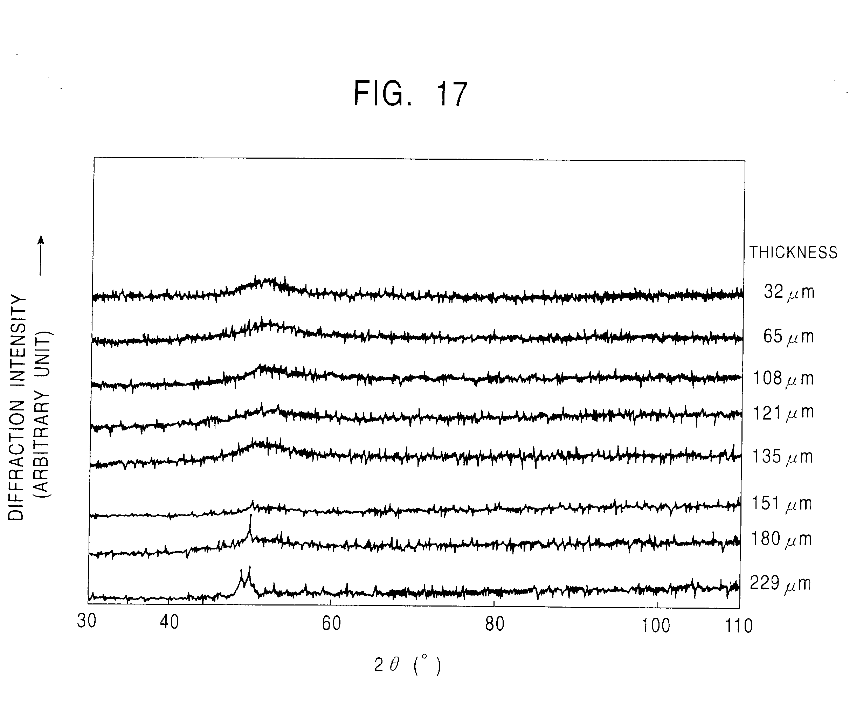

Fig. 17 shows an X-ray diffraction pattern of each of the glassy alloy samples obtained under the conditions shown in Table 1. In the X-ray diffraction patterns shown in Fig. 17, all samples having a thickness of 35 to 135 pm show halo patterns and thus exhibit an amorphous single phase texture. On the other hand, each of samples respectively having a thickness of 151 and 180 µm shows a peak near 2θ = 50°. This peak is considered as a peak due to Fe₂B. A sample having a thickness of 229 µm shows a peak due to Fe₃B other than the Fe₂B peak, and another compound is possibly produced.

These results indicate that a glassy alloy ribbon having a thickness in the range of 35 to 135 µm can be produced from the composition Fe₇₃A₅Ga₂P₁₁C₅B₄ by the single roll method.

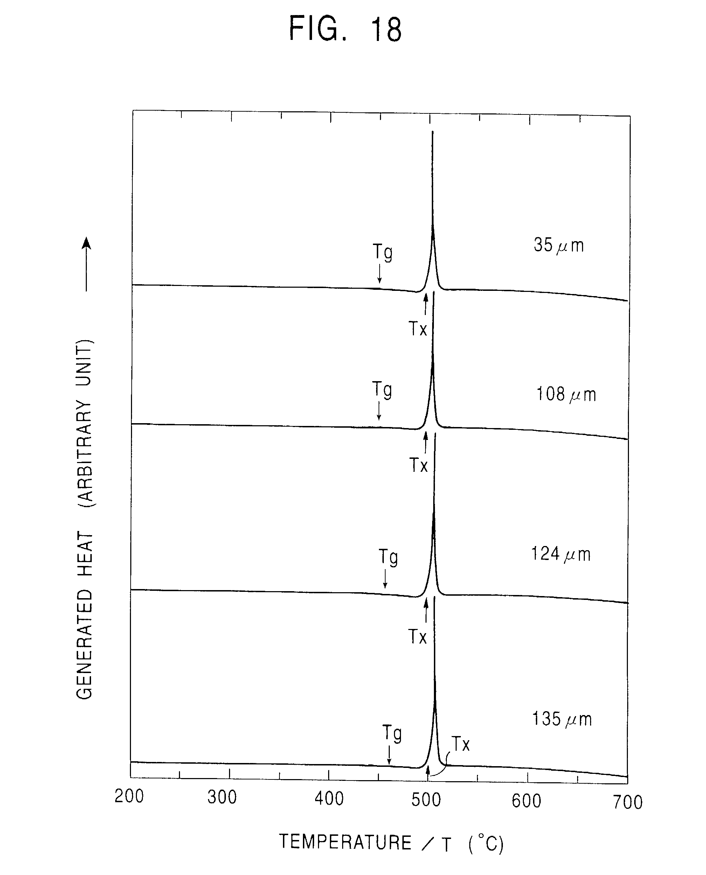

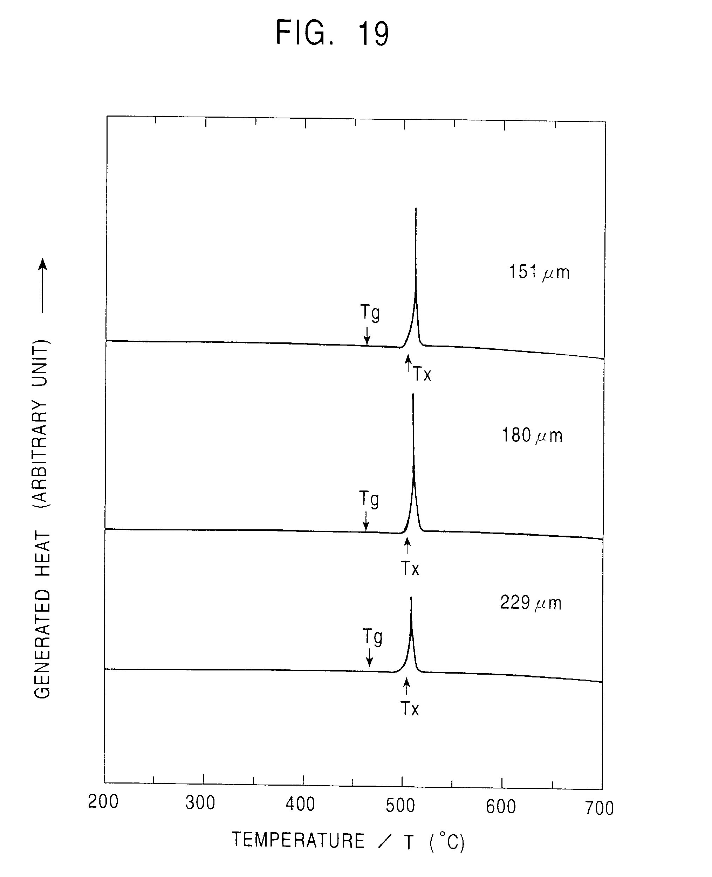

Fig. 18 and 19 show a DSC (Differential Scanning Calorimetry) curve of each of the glassy alloy samples produced under the conditions shown in Table 2. These figures reveal that this system of composition has a supercooled liquid region below the crystallization temperature Tx having a wide temperature wide expressed by the equation ΔTx = Tx - Tg, and has the high ability to form an amorphous phase. Also these figures indicate that even a sample having a thickness of 229 µm has an amorphous phase.

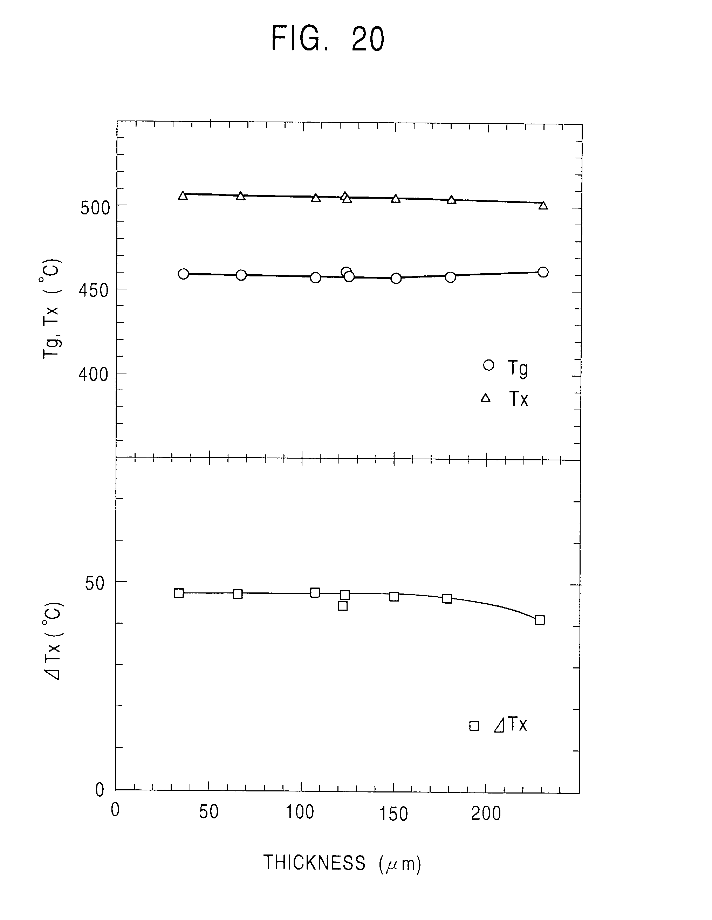

Fig. 20 shows the dependency of ΔTx, Tg and Tx on the thickness determined from the DSC curve of each of the glassy alloy samples shown in Figs. 18 and 19. The results shown in Fig. 20 indicate that the Tx value does not have the tendency to change depending upon the thickness, but is constant at about 506°C. Tg is substantially constant (Tg = 458C) except the sample having a thickness of 229 µm and exhibiting a slight increase in Tg. ΔTx determined from Tx and Tg is substantially constant (ΔTx = 47°C) except the sample having a thickness of 229 µm and exhibiting a slight increase in Tg. All samples satisfy the limit conditions of the present invention in that ΔTx is 35°C or more.

### EXAMPLE 4

### Fe-Al-Ga-P-C-B glassy alloy:

Next, the Fe concentration was changed to various values in the composition range of Fe₇₀₊ₓA₅Ga₂(P₅₅C₂₅B₂₀)₂₃₋ₓ (wherein the numerals in parentheses are by atomic % on the basis of the total P+C+B of 100) to produce ribbon-shaped glassy alloy samples by the same method as Example 1. These Fe-Al-Ga-P-C-B glassy alloy samples were examined with respect to the structures and characteristics thereof. The samples had a constant thickness of 30 µm.

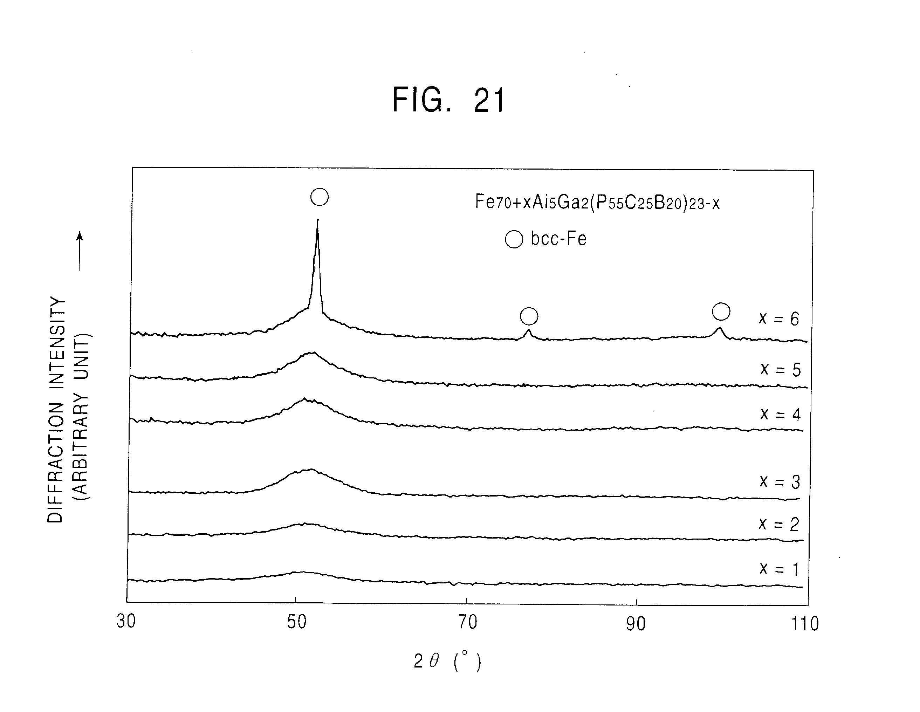

Fig. 21 shows an X-ray diffraction pattern of each of the glassy alloy samples. This figure indicates that all samples having a Fe concentration of 71 to 75 atomic % (X = 1 to 5) show halo patterns, and thus exhibit formation of an amorphous single phase texture. On the other hand, a sample having a Fe concentration of 76 atomic % (X = 6) shows peaks (marked with o in the figure) which are possibly due to bcc-Fe, and it is thus found that a crystal is partially produced.

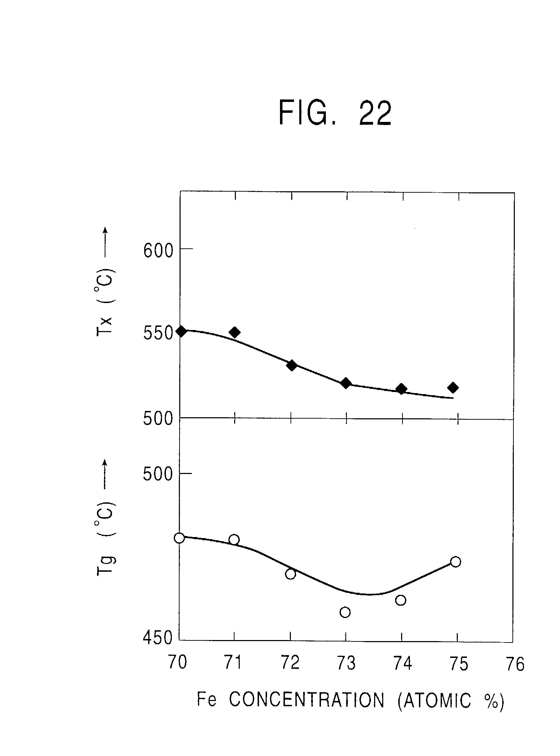

Fig. 22 shows the dependency of Tx and Tg on the Fe concentration which was determined from the DSC curve (not shown) of each of the glassy alloy samples. In Fig. 22, the Tx value decreases with increases in the Fe concentration in the Fe concentration range of 70 to 75 atomic %. The Tg value decreases with increases in the Fe concentration in the Fe concentration range of 70 to 73 atomic %, and increases as the Fe concentration increases from this range. However, in all samples, ΔTx determined from Tx and Tg is 35 to 70°C, and thus it can be said that all glassy alloys in the composition range satisfy the limit condition of the present invention.

### EXAMPLE 5

### Fe-Al-Ga-P-C-B-Si glassy alloy:

Ribbon samples of a Fe-Al-Ga-P-C-B-Si glassy alloy were produced by adding Si to the Fe-Al-Ga-P-C-B composition.

An ingot of a composition of Fe₇₂A₅Ga₂P₁₀C₆B₄Si was produced, melted in a crucible, and then quenched by the single roll method in an Ar atmosphere under reduced pressure to obtain ribbon-shaped glassy alloy samples. As conditions for production, the nozzle diameter was set to 0.4 to 0.5 mm, the gap between the nozzle tip and the roll surface was set to 0.33 mm, the rotational speed of the roll was et to 200 to 2500 rpm, the injection pressure was set to 0.35 to 0.40 kgf/cm², the atmospheric pressure was set to - 10 cmHg, and the roll surface state was set to #1000. Under these conditions, ribbon-shaped products of 20 to 250 µm thick were obtained. Hereinafter, of both surfaces of each of the samples obtained, the side in contact with the roll surface is referred to as "the roll surface side", and the opposite side is referred to as "the free surface side".

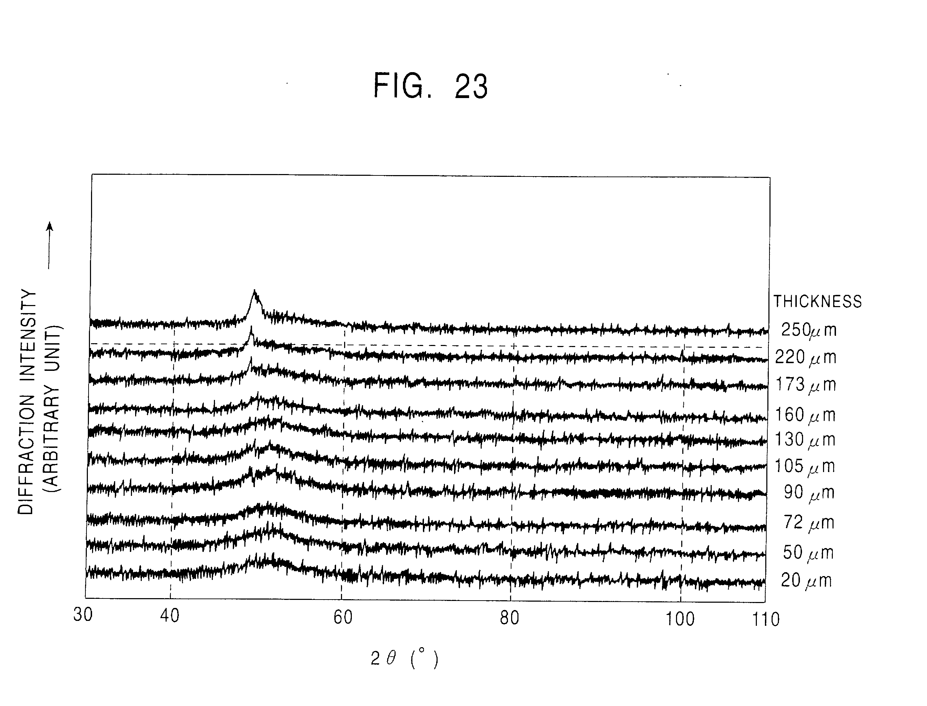

Fig. 23 shows an X-ray diffraction pattern of each of the thus-obtained glassy alloy samples. Each of the ribbon samples was measured on the free surface side. The X-ray diffraction patterns shown in Fig. 23 indicate that all samples having a thickness of 20 to 160 µm have a halo pattern at 2θ = 40 to 60°, and thus have an amorphous single phase texture. On the other hand, the sample having a thickness of 170 µm shows only a peak near 2θ = 50°. This peak possibly due to Fe₃C and Fe₃B.

These results indicate that in this example, a ribbon-shaped product having an amorphous single phase texture and a thickness in the range of 20 to 160 µm can be obtained by the single roll method. With the composition of this example, an amorphous single phase texture having a thickness of up to about 135 µm can be obtained, and a peak due to crystallization is observed with a thickness of 151 µm. It is thus found that the addition of Si improves the thickness which allows formation of an amorphous single phase texture, i.e., the critical thickness.

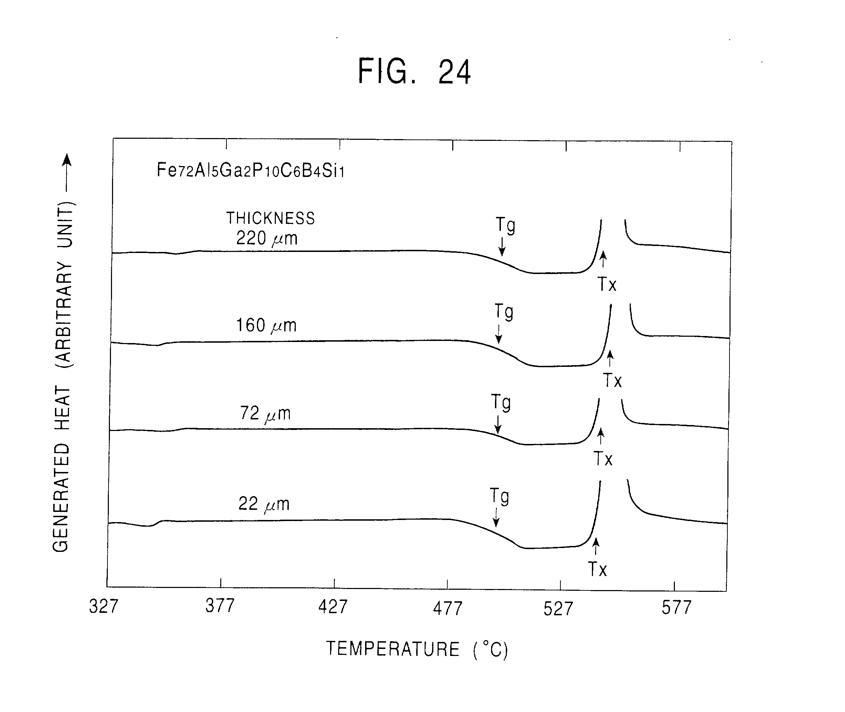

Fig. 24 shows a DSC (Differential Scanning Calorimetry) curve of each of the ribbon-shaped samples having a thickness of 22 to 220 µm. The heating rate was 0.67 °C/sec. This figure reveals that each of the samples has a supercooled liquid region having a wide temperature width below the crystallization temperature, and that this system of composition has the high ability to form an amorphous phase.

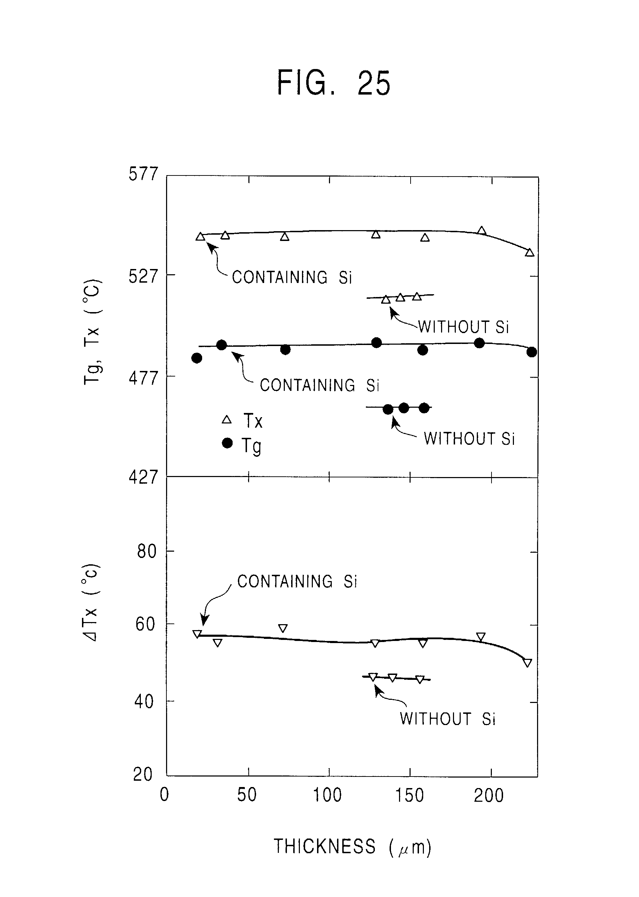

Fig. 25 shows the results of examination of the dependency of Tx, Tg and ΔTx on the thickness, which was determined from the DSC curve of each of the glassy alloy samples of Example 5 and the same samples as Example 5 except that Si was not added. In Fig. 25, Tx, Tg and ΔTx are shown by Δ, • and ∇, respectively.

In this figure, all samples do not have the tendency that Tx, Tg and ΔTx change depending upon the thickness. It is also found that a sample containing Si shows ΔTx of about 51°C which is about 4°C larger than ΔTx of a sample not containing Si. In this example, of course, the present invention include both a sample containing Si and a sample not containing Si.

### EXAMPLE 6

Predetermined amounts of Fe, Al, Ga, a Fe-C alloy, a Fe-P alloy and B were weighed as raw materials and mixed, and the resultant mixture containing these raw materials was melted by a high-frequency induction heating furnace in an Ar atmosphere under reduced pressure to form a master alloy.

The master alloy was melted in a crucible and quenched by the single roll method in which the melt was sprayed on a rotating roll from the nozzle of the crucible in an Ar atmosphere under reduced pressure to obtain a quenched ribbon having the composition Fe₇₃A₅Ga₂P₁₁C₅B₄. At this time, the nozzle diameter, the gap between the nozzle tip and the roll surface, the rotational speed of the roll, the injection pressure, and the atmospheric pressure were appropriately adjusted to obtain ribbon samples having a thickness of 35 to 229 µm.

The magnetic characteristics of the thus-obtained ribbon sampled were measured after heat treatment in the temperature range of 300 to 450°C. As conditions of heat treatment, an infrared image furnace was used, the heating rate in vacuum was 180 °C/min, and the holding temperature was 10 minutes.

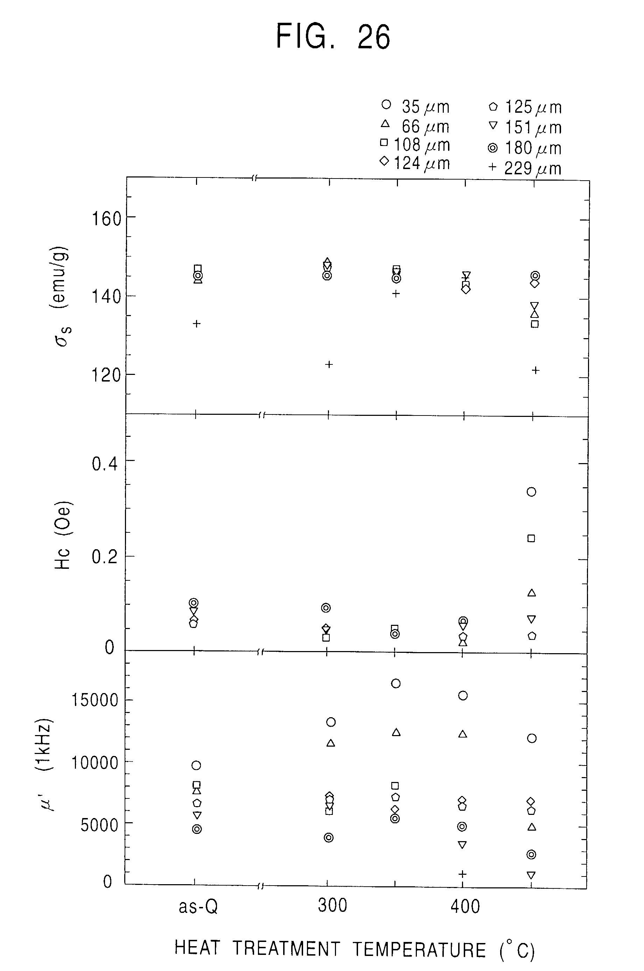

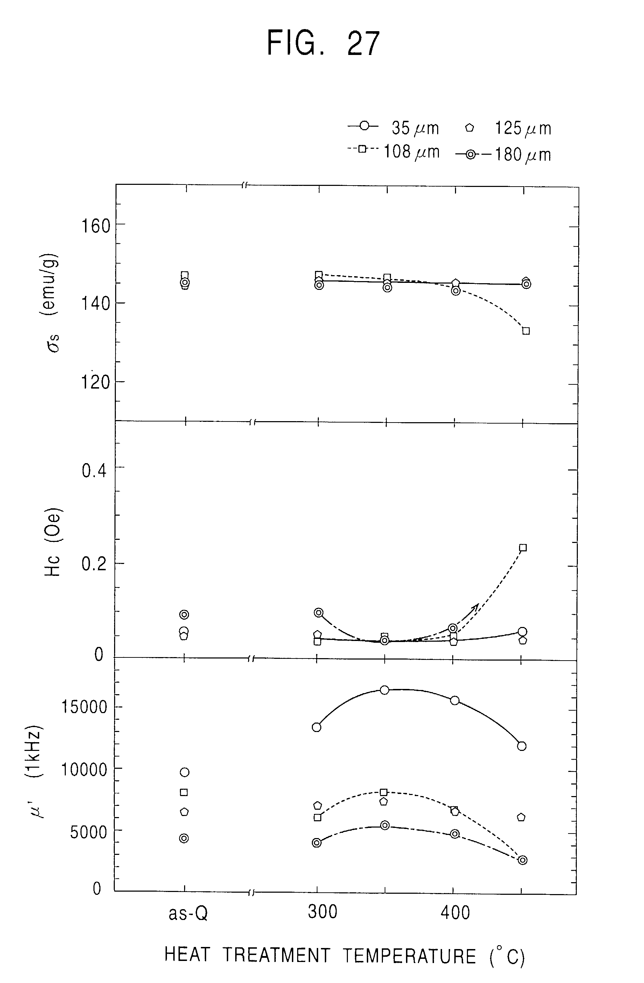

Fig. 26 shows the dependency of the magnetic characteristics on the heat treatment temperature of each of the ribbon samples. Fig. 27 shows only a necessary number of items of data extracted from the data shown in Fig. 26.

In these figures, like the samples obtained without heat treatment, the samples having a thickness in the range of 35 to 180 µm show a substantially constant value of saturation magnetization (σₛ) up to about 400°C. However, after heat treatment at 450°C, saturation magnetization tends to slightly deteriorate. On the other hand, the ribbon sample having a thickness of 229 µm shows the tendency that saturation magnetization peaks at 400°C and then deteriorates. This is possibly due to growth of a crystal of Fe3B or the like at 400°C or more.

In regard to coercive force (H_{c}), the ribbon samples obtained without heat treatment and comprising an amorphous phase show the tendency that coercive force is a substantially constant value up to a thickness of 125 µm, and increases as the thickness increases from 125 µm. Also coercive force tends to decrease by heat treatment up to a temperature of 400°C.

In regard to magnetic permeability µ' (1 kHz), the ribbon samples obtained without heat treatment and comprising an amorphous phase show the tendency that magnetic permeability is a substantially constant value up to a thickness of 125 µm, and decreases as the thickness increases from 125 µm. Although magnetic permeability is improved by the effect of heat treatment up to 400°C, magnetic permeability tends to significantly deteriorate by heat treatment at 450°C. Also the effect of heat treatment decreases with increases in the thickness.

These changes in soft magnetic characteristics with heat treatment are possibly caused by the phenomenon that the internal stress present in a ribbon sample without heat treatment is relieved by heat treatment. In this test, the optimum heat treatment temperature Tₐ is about 350°C.

Since heat treatment at a temperature below the Curie temperature Tc possibly causes deterioration in soft magnetic characteristics due to magnetic domain fixing, the heat treatment temperature is thought to be 300°C or higher.

Also heat treatment at 450°C tends to cause more deterioration in magnetic characteristics than the ribbon samples obtained without heat treatment. This heat treatment temperature is close to the crystallization temperature (about 500°C) of this system, and thus deterioration is possibly caused by pinning of the magnetic domain walls due to the start of generation of crystal nuclei (ordering of low order structure) or the start of crystallization. Therefore, it was found that the heat treatment temperature is preferably 300 to 500°C, i.e., in the range of 300°C to the crystallization temperature, and more preferably 300 to 450°C.

Table 2 summarizes the saturation magnetization (σₛ), coercive force (H_{c}), magnetic permeability (µ'), temperature widths (ΔTx) of supercooled liquid regions and texture structures of the ribbon samples of Example 6. The structure is shown by the result of structure analysis of XRD (X-Ray Diffraction), amo indicating an amorphous single phase, and amo+cry indicating a structure having an amorphous phase and a crystalline phase.

In regard to ΔTx, all samples show a substantially constant value (ΔTx = 47°C) except the sample having a thickness of 229 µm.

**Table 2**

| Thickness (µm) | σₛ (emu/g) | H_{c} (Oe) | µ' (1 kHz) | ΔTx (°C) | Structure (XRD) |
|---|---|---|---|---|---|
| 108 | 146.7 | 0.057 | 8280 | 48.073 | amo |
| 151 | 145.2 | 0.048 | 5786 | 46.801 | amo+cry |
| 66 | 143.7 | 0.047 | 7724 | 47.455 | amo |
| 124 | 144.7 | 0.054 | 6750 | 46.887 | amo |
| 135 | 144.0 | 0.047 | 6863 | 47.279 | amo |
| 35 | 144.1 | 0.072 | 9769 | 47.719 | amo |
| 180 | 145.0 | 0.089 | 4627 | 46.405 | amo+cry |
| 229 | 132.6 | - | 32 | 41.358 | amo+cry |

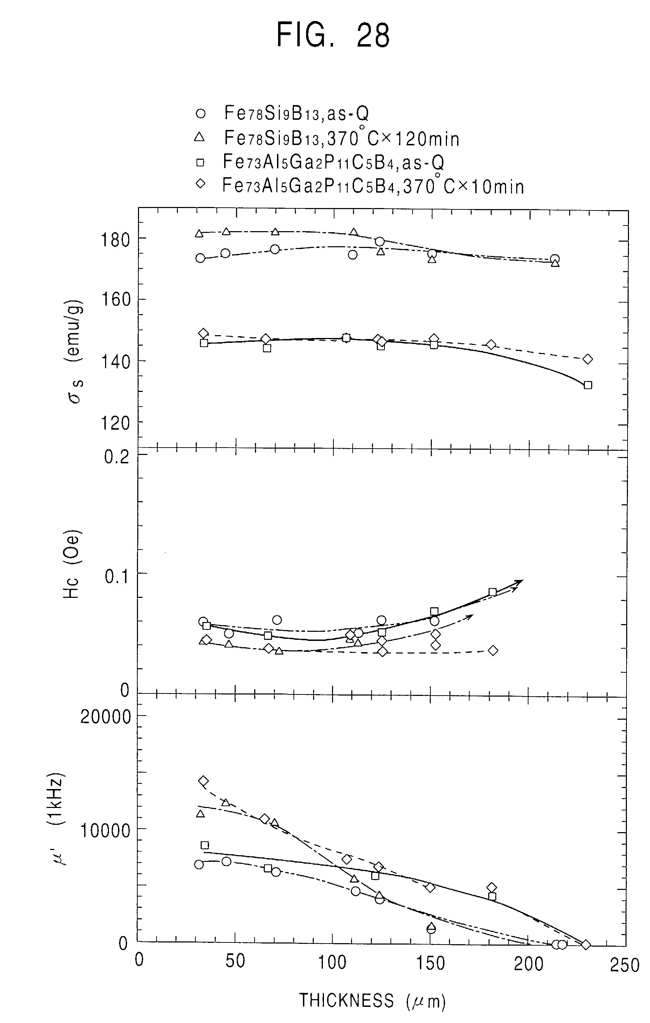

Fig. 28 shows the results of measurement of the dependency of saturation magnetization (σₛ), coercive force (H_{c}) and magnetic permeability (µ') on the thickness with respect to each of a comparative sample having the composition Fe₇₈Si₉B₁₃ and obtained without heat treatment, the same comparative sample obtained after heat treatment at 370°C for 120 minutes, a ribbon sample of Example 1 obtained without heat treatment, and the same ribbon sample of Example 1 obtained after heat treatment at 350°C for 10 minutes.

In all samples, in the thickness range of 30 to 200 µm, the magnetic characteristics less deteriorated, and excellent characteristics were obtained.

As described above, since the Fe-based glassy alloy of Example 1 exhibits good soft magnetic characteristics, and thus has the excellent MI effect, an autocanceller using this alloy is capable of sensing weak external magnetization.

Also, the temperature width ΔTx is large, and thus a MI element having a large thickness can be obtained, thereby decreasing the productive cost of the autocanceller.

### EXAMPLE 7

In this example, the advantageous effects of a Fe-based glassy alloy formed by adding Si to the composition of Example 6 were clarified.

An ingot having the composition Fe₇₂A₅Ga₂P₁₀C₆B₄Si was formed, melted in a crucible and then quenched by the single roll method comprising spraying the melt to a rotating roll from the nozzle of the crucible to obtain a quenched ribbon in an Ar atmosphere under reduced pressure. As conditions for production, the nozzle diameter was set to 0.4 to 0.5 mm, the gap between the nozzle tip and the roll surface was set to 0.3 mm, the rotational speed of the roll was set to 200 to 2500 rpm, the injection pressure was set to 0.35 to 0.40 kgf/cm², the atmospheric pressure was set to -10 cmHg, and the roll surface state was set to #1000. As a result, ribbon samples having a thickness of 20 to 250 µm were obtained.

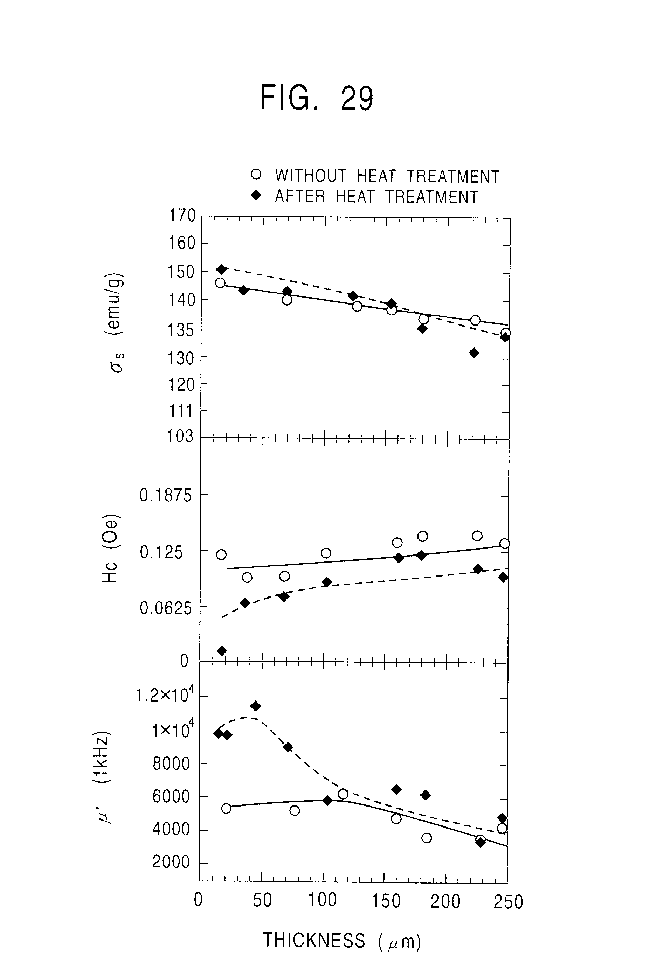

The magnetic characteristics of each of the thus-obtained ribbon samples were measured without heat treatment and after heat treatment. Fig. 29 shows the dependency of the magnetic characteristics of each ribbon sample on the thickness. As conditions for heat treatment, an infrared image furnace was used, the atmosphere was a vacuum, the heating rate was 180 °C/min which was the optimum condition for the sample of Example 1 without Si added, the holding temperature was 350°C, and the holding time was 30 minutes.

This figure reveals that without heat treatment, saturation magnetization (σₛ) is substantially constant at about 145 emu/g regardless of the thickness, and after heat treatment, saturation magnetization (σₛ) is substantially the same as that without heat treatment up to a thickness of 160 µm with which an amorphous single structure is maintained, and tends to significantly deteriorate with a thickness over 160 µm as compared with the samples obtained without heat treatment. This is possibly due to the growth of crystals of Fe₃B, Fe₃C, and the like in heat treatment.

In regard to coercive force (H_{c}), the samples without heat treatment showed the tendency that coercive force (H_{c}) increases with increases in the thickness. In the samples after heat treatment, coercive force (H_{c}) deteriorated as compared with the samples without heat treatment, and the value was 0.625 to 0.125 Oe with any one of the thicknesses.

The reason for the decrease in coercive force (H_{c}) by heat treatment is possibly that like in Example 6, the internal stress present in the samples without heat treatment is relieved by heat treatment.

In regard to magnetic permeability (µ' (1 kHz)), the samples without heat treatment showed that tendency that the magnetic permeability decreases with increases in the thickness. The magnetic permeability (µ') was improved by heat treatment, and a value equivalent to that of the Fe-based glassy alloy of Example 6 having the composition not containing Si was obtained. Like in Example 6, this embodiment showed the tendency that the effect of heat treatment decreases as the thickness increases.

Table 3 summarizes the saturation magnetization (σₛ), coercive force (H_{c}), temperature width (ΔTx) of supercooled liquid region, magnetic permeability and texture structure of each of the thick samples (without heat treatment) obtained in this example.

**Table 3**

| Thickness (µm) | H_{c} (Oe) | σₛ(x10⁻⁶ Wbm/kg) | µ' (1 kHz) | ΔTx (°C) | Structure (XRD) |
|---|---|---|---|---|---|
| 20 | 0.119 | 185 | 5321 | - | amo |
| 50 | 0.090 | 184 | 5800 | - | amo |
| 72 | 0.099 | 182 | 5800 | - | amo |
| 90 | 0.106 | 180 | 5810 | - | amo |
| 105 | 0.126 | 179 | 5795 | - | amo |
| 130 | 0.116 | 178 | 5000 | - | amo |
| 160 | 0.119 | 179 | 4987 | 51.7 | amo |
| 173 | 0.120 | 179 | 4831 | 50.9 | amo+cry |
| 220 | 0.123 | 173 | 4200 | - | amo+cry |
| 250 | 0.126 | 170 | 4000 | - | amo+cry |

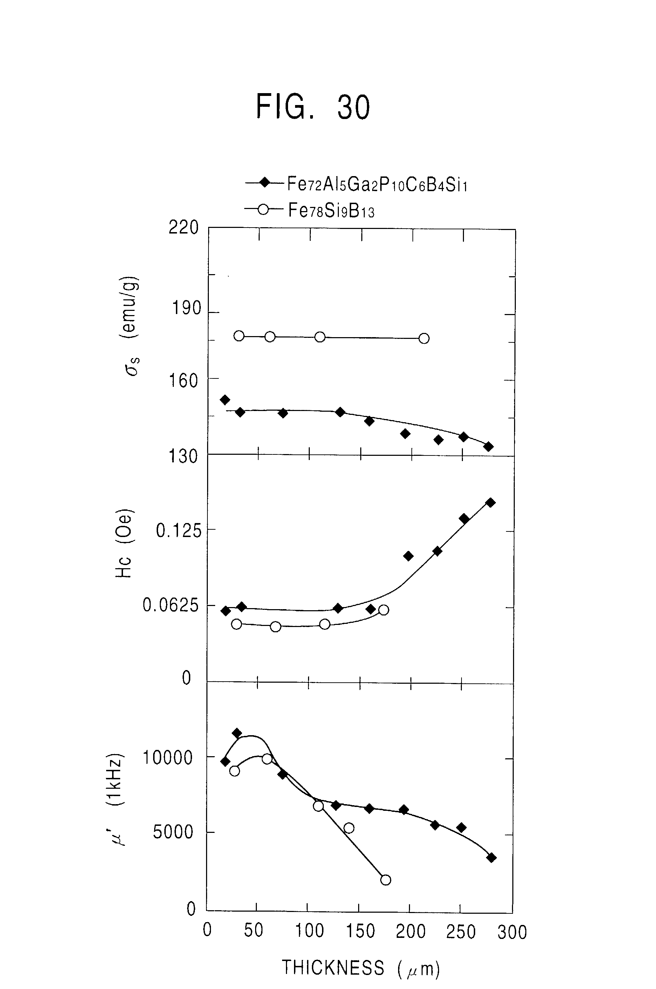

Fig. 30 shows the results of measurement of the dependency of saturation magnetization (σₛ), coercive force (H_{c}) and magnetic permeability (µ') on the thickness with respect to each of a comparative sample having the composition Fe₇₈Si₉B₁₃ after heat treatment at 370°C for 120 minutes and a sample having the composition Fe₇₂A₅Ga₂P₁₀C₆B₄Si after heat treatment at 350°C for 30 minutes.

The results indicate that the Fe-based soft magnetic glassy alloy sample of the present invention having the composition Fe₇₂A₅Ga₂P₁₀C₆B₄Si exhibits less deterioration in magnetic characteristics and excellent properties in the thickness range of 20 to 250 µm, as compared with the conventional comparative sample having the composition Fe₇₈Si₉B₁₃.

Particularly, in regard to soft magnetic characteristics, the sample of the present invention shows an excellent value of magnetic permeability as compared with the conventional material, and a 1 kHz magnetic permeability of 5000 or more is obtained in the thickness range of 20 to 250 m.

The magneto-impedance effect is related to saturation magnetization and magnetic permeability, particularly magnetic permeability. Therefore, the Fe-based glassy alloy of the present invention having excellent magnetic characteristics can be expected to have the excellent magneto-impedance effect.

## Claims

1. A magneto-impedance effect element comprising a Fe-based glassy alloy containing Fe as a main component and having a supercooled liquid region having a temperature width ΔTx of 35°C or more, which is expressed by the equation ΔTx = Tx - Tg (wherein Tx is the crystallization temperature, and Tg is the glass transition temperature), wherein impedance changes depending upon an external magnetic field with an alternating current applied.

2. The magneto-impedance effect element according to Claim 1, wherein the Fe-based glassy alloy contains a metal element other than Fe, and a semimetal element.

3. The magneto-impedance effect element according to Claim 2, wherein the metal element other than Fe is at least one selected from the group consisting of the 3B group elements and the 4B group elements in the periodic table.

4. The magneto-impedance effect element according to Claim 2, wherein the metal element other than Fe is at least one selected from the group consisting of Al, Ga, In and Sn.

5. The magneto-impedance effect element according to Claim 2, wherein the semimetal element is at least one selected from the group consisting of P, C, B. Ge and Si.

6. The magneto-impedance effect element according to Claim 2, wherein the semimetal element comprises a group containing at least three elements of P, B and C.

7. The magneto-impedance effect element according to Claim 1, wherein the Fe-based glassy alloy has a composition, by atomic %, containing:
Al; 1 to 10
Ga; 0.5 to 4
P; 9 to 15
C; 5 to 7
B; 2 to 10
Si; 0 to 15
Fe; balance

8. The magneto-impedance effect element according to Claim 7, containing Ga in the range of 4 atomic % or less.

9. The magneto-impedance effect element according to Claim 7, containing at least one selected from the group consisting of Nb, Mo, Hf, Ta, W, Zr and Cr in the range of 7 atomic % or less.

10. The magneto-impedance effect element according to Claim 7, containing at least one selected from the group consisting of Ni and Co in the range of 10 atomic % or less.

11. The magneto-impedance effect element according to Claim 7, wherein the Fe-based glassy alloy is subjected to heat treatment in the range of 300 to 500°C.

12. A magnetic head comprising a magneto-impedance effect element comprising a Fe-based glassy alloy containing Fe as a main component and having a supercooled liquid region having a temperature width ΔTx of 20°C or more, which is expressed by the equation ΔTx = Tx - Tg (wherein Tx is the crystallization temperature, and Tg is the glass transition temperature)

13. The magnetic head according to Claim 12, further comprising a pair of cores, and junction glass joined to each of the pairs of cores to be held thereberween, wherein the magneto-impedance effect element is arranged over the pair of cores so that an external magnetic field is applied to the magneto-impedance effect element through the pair of cores.

14. The magnetic head according to Claim 13, wherein the pair of cores comprise ferrite.

15. The magnetic head according to Claim 13, wherein a winding groove is provided between both ends of each of the pair of cores so that a recording coil is wound in the winding groove.

16. The magnetic head according to Claim 12, wherein bias applying means is provided on the magneto-impedance effect element.

17. The magnetic head according to Claim 16, wherein the bias applying means comprises a bias coil wound in the winding groove.

18. The magnetic head according to Claim 16, wherein the bias applying means comprises permanent magnet provided at the end of the magneto-impedance effect element.

19. A thin film magnetic head comprising a magneto-impedance effect element thin film for sensing an external magnetic field mainly comprising a Fe-based glassy alloy having a supercooled liquid region having atemperature width ΔTx of 20°C or more, which is expressed by the equation ΔTx = Tx - Tg (wherein Tx is the crystallization temperature, and Tg is the glass transition temperature), and producing a change in impedance due to an external magnetic field.

20. The thin film magnetic head according to Claim 19, further comprising a writing head and a reading head both of which are provided in a slider relatively moving with a surface opposite to a magnetic medium, the writing head having a magnetic induction type structure comprising thin film upper core and lower core, and a magnetic gap and a coil conductor provided between both cores, and the reading head comprising the magneto-impedance effect element thin film and an electrode film connected to the magneto-impedance effect element thin film.

21. The thin film magnetic head according to Claim 19, wherein bias applying means is provided on the magneto-impedance effect element thin film.

22. The thin film magnetic head according to Claim 21, wherein the bias applying means comprises a permanent magnet connected to the magneto-impedance effect element thin film.

23. The thin film magnetic head according to Claim 21, wherein the bias applying means comprises a ferromagnetic thin film laminated on the magneto-impedance effect element thin film, and an antiferromagnetic thin film laminated on the ferromagnetic thin film so that a bias is applied by an exchange coupling magnetic field induced in the ferromagnetic thin film by the antiferromagnetic thin film.

24. An electronic compass comprising, as means for sensing the direction of lines of magnetic force of an external magnetic field, a magneto-impedance effect element comprising a Fe-based glassy alloy containing Fe as a main component and having a supercooled liquid region having a temperature width ΔTx of 20°C or more, which is expressed by the equation ΔTx = Tx - Tg (wherein Tx is the crystallization temperature, and Tg is the glass transition temperature).

25. The electronic compass according to Claim 24, further comprising:
a first magneto-impedance effect element as means for sensing the X-axis component of the lines of magnetic force of the external magnetic field; and
a second magneto-impedance effect element as means for sensing the Y-axis component of the lines of magnetic force of the external magnetic field.

26. The electronic compass according to Claim 25, wherein the first and second magneto-impedance effect elements are arranged in the same plane so that the current paths of the alternating currents respectively applied to the first and second magneto-impedance effect elements cross each other at right angles.

27. The electronic compass according to Claim 26, wherein a coil is wound on each of the first and second magneto-impedance effect elements, for applying bias magnetization along the current path of the alternating current applied to each of the elements.

28. An autocanceller comprising:
a cancel coil for applying to, a cathode ray tube, a cancel magnetic field having the same magnitude as an external magnetic field in the direction opposite to the external magnetic field; and
a control unit for controlling the magnitude of the cancel magnetic field on the basis of the direction of lines of magnetic force of the external magnetic field sensed by a magnetic sensor;
wherein the magnetic sensor comprises a magneto-impedance effect element comprising a Fe-based glassy alloy containing Fe as a main component and having a supercooled liquid region having a temperature width ΔTx of 20°C or more, which is expressed by the equation ΔTx = Tx - Tg (wherein Tx is the crystallization temperature, and Tg is the glass transition temperature).

29. The autocanceller according to Claim 28, wherein the magnetic sensor comprises:
a first magneto-impedance effect element as means for sensing the X-axis component of the lines of magnetic force of the external magnetic field; and
a second magneto-impedance effect element as means for sensing the Y-axis component of the lines of magnetic force of the external magnetic field.

30. The autocanceller according to Claim 29, wherein the first and second magneto-impedance effect elements are arranged in the same plane so that the current paths of the alternating currents respectively applied to the first and second magneto-impedance effect elements cross each other at right angles.

31. The autocanceller according to Claim 30, wherein a coil is wound on each of the first and second magneto-impedance effect elements, for applying bias magnetization along the current path of the alternating current applied to each of the elements.
